(19) Europäisches Patentamt / European Patent Office / Office européen des brevets

(11) **EP 4 557 610 A2**

(12) **EUROPEAN PATENT APPLICATION**


(43) Date of publication:
**21.05.2025 Bulletin 2025/21**

(21) Application number: **24208527.2**

(22) Date of filing: **24.10.2024**

(51) International Patent Classification (IPC):
***H03F 1/02*** *(2006.01)* ***H03F 1/56*** *(2006.01)*
***H03F 3/195*** *(2006.01)* ***H03F 3/24*** *(2006.01)*

(52) Cooperative Patent Classification (CPC):
**H03F 3/245; H03F 1/0288; H03F 1/565; H03F 3/195;** H03F 2200/387; H03F 2200/451; H03F 2203/21169; H03F 2203/21172

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **27.10.2023 KR 20230145770**



(71) Applicant: **Samsung Electronics Co., Ltd.**
**Suwon-si, Gyeonggi-do 16677 (KR)**

(72) Inventors:
- **OH, Sungjae**
  **16677 Suwon-si, Gyeonggi-do (KR)**
- **KANG, Hyunuk**
  **16677 Suwon-si Gyeonggi-do (KR)**
- **LEE, Daeyoung**
  **16677 Suwon-si, Gyeonggi-do (KR)**

(74) Representative: **Gulde & Partner**
**Patent- und Rechtsanwaltskanzlei mbB**
**Berliner Freiheit 2**
**10785 Berlin (DE)**


(54) **DEVICE INCLUDING POWER AMPLIFIER IN WIRELESS COMMUNICATION SYSTEM**


(57) The disclosure relates to a fifth generation (5G) communication system or a sixth generation (6G) communication system. An electronic device in a wireless communication system can reduce or minimize the size of a power amplifier module (PAM) and can secure a relatively wide operating frequency band of the PAM.


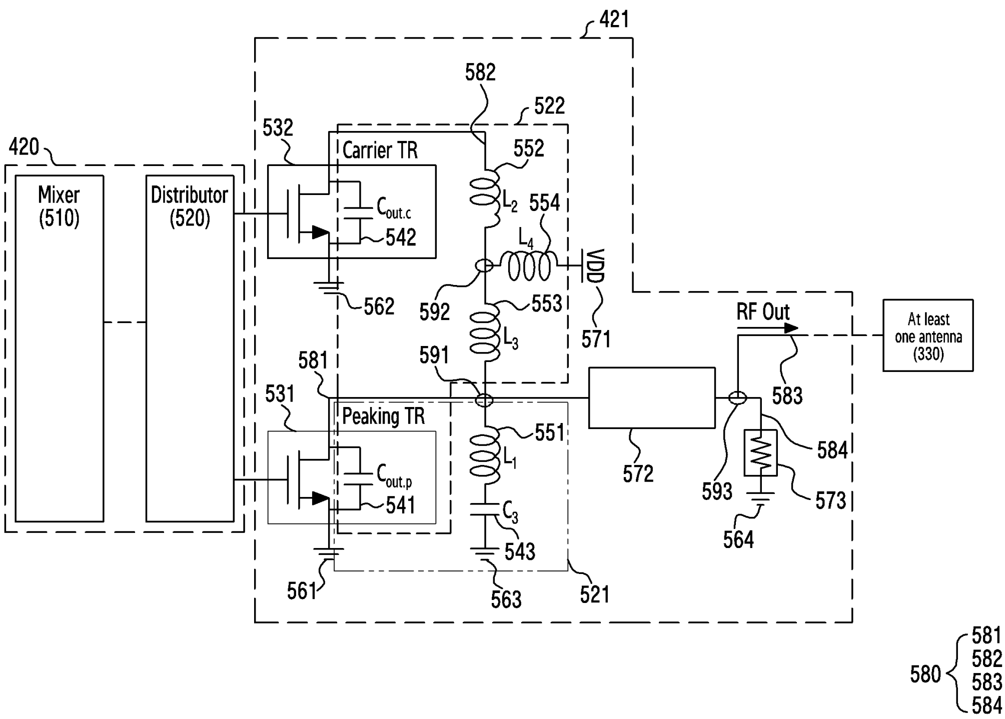


FIG.5

EP 4 557 610 A2

## Description

[TECHNICAL FIELD]

The disclosure relates generally to a wireless communication system, and more particularly, to a device including a power amplifier (PA) in a wireless communication system.

[BACKGROUND ART]

Based on the development of wireless communication, technologies have been developed mainly for services targeting humans, such as voice calls, multimedia services, and data services. Following the commercialization of fifth generation (5G) communication systems, it is expected that the number of devices that will be connected to communication networks will exponentially grow. Such connected devices may include vehicles, robots, drones, home appliances, displays, smart sensors connected to various infrastructures, construction machines, and factory equipment.

Mobile devices are expected to evolve in various form-factors, such as augmented reality glasses, virtual reality headsets, and hologram devices. To provide various services by connecting hundreds of billions of devices and things in the sixth generation (6G) era, there have been ongoing efforts to develop improved 6G communication systems, which are referred to as beyond-5G systems.

6G communication systems are expected to be commercialized around 2030, will have a peak data rate of tera (1,000 giga)-level bit per second (bps) and a radio latency less than 100 microseconds (μsec), and thus will be 50 times as fast as 5G communication systems and have the 1/10 radio latency thereof.

To achieve such a high data rate and an ultra-low latency, it has been considered to implement 6G communication systems in a terahertz (THz) band, such as 95 gigahertz (GHz) to 3THz bands. It is expected that, due to more severe path loss and atmospheric absorption in the THz bands than those in millimeter wave (mmWave) bands introduced in 5G, technologies capable of securing the signal transmission distance (i.e., coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple-input multiple-output (MIMO), full dimensional MIMO (FD-MIMO), array antennas, and multiantenna transmission technologies such as large-scale antennas. In addition, there has been ongoing discussion on new technologies for improving the coverage of THz band signals, such as metamaterial-based lenses and antennas, orbital angular momentum (OAM), and reconfigurable intelligent surface (RIS).

Moreover, to improve the spectral efficiency and the overall network performances, the following technologies have been developed for 6G communication systems: a full-duplex technology for enabling an uplink transmission and a downlink transmission to simultaneously use the same frequency resource , a network technology for utilizing satellites, high-altitude platform stations (HAPS), and the like in an integrated manner, an improved network structure for supporting mobile base stations and the like and enabling network operation optimization and automation, etc., a dynamic spectrum sharing technology via collision avoidance based on a prediction of spectrum usage, use of artificial intelligence (AI) in wireless communication for improvement of overall network operation by utilizing AI from a designing phase for developing 6G and internalizing end-to-end AI support functions, and a next-generation distributed computing technology for overcoming the limit of UE computing ability through reachable super-high-performance communication and computing resources (such as mobile edge computing (MEC), clouds, etc.) over the network. In addition, through designing new protocols to be used in 6G communication systems, developing mechanisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will enable the next hyper-connected experience to be realized. Particularly, it is expected that services such as truly immersive extended Reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

[Disclosure]

[Technical Solution]

In accordance with an aspect of the disclosure, an electronic device in a wireless communication system may include a first transistor configured to receive a first signal and comprising a first capacitor, the first transistor being configured to amplify and output the first signal as a first RF signal in case that the first signal is greater than or equal to a specified voltage, a second transistor configured to receive a second signal and comprising a second capacitor, the second transistor being configured to amplify and output the second signal as a second RF signal, a first connection line which is connected to the first transistor and in which the first RF signal is transmitted, a second connection line which is connected to the second transistor and in which the second RF signal is transmitted, the first connection line and the second connection line being connected at a first node, a first inductor connected to the first node, and a third capacitor configured to connect the first inductor and ground, wherein an impedance sum of the first inductor, the first capacitor, and the third capacitor is configured such that the first RF signal and the second RF signal resonate in a specified frequency band.

In accordance with an aspect of the disclosure, a PAM may include a first transistor configured to receive a first signal and comprising a first capacitor, the first transistor being configured to amplify and output the first signal as a first RF signal in case that the first signal is greater than or equal to a specified voltage, a second transistor configured to receive a second signal and comprising a second capacitor, the second transistor being configured to amplify and output the second signal as a second RF signal, a first connection line which is connected to the first transistor and in which the first RF signal is transmitted, a second connection line which is connected to the second transistor and in which the second RF signal is transmitted, the first connection line and the second connection line being connected at a first node, a first inductor connected to the first node, and a third capacitor configured to connect the first inductor and ground, wherein a sum of impedances of the first inductor, the first capacitor, and the third capacitor is configured such that the first RF signal and the second RF signal resonate in a specified frequency band.

**[Description of Drawings]**

The above and other aspects, features, and advantages of certain embodiments of the disclosure will be more apparent from the following description taken in conjunction with the accompanying drawings, in which:

FIG. 1 illustrates a wireless communication system according to an embodiment;
FIG. 2 illustrates an electronic device according to an embodiment;
FIG. 3 illustrates an electronic device according to an embodiment;
FIG. 4 illustrates at least one antenna and at least one transceiver according to an embodiment;
FIG. 5 illustrates an RF integrated circuit (RFIC) and a first PAM according to an embodiment;
FIG. 6 illustrates a first PAM implemented on a printed circuit board (PCB) and a plurality of chips according to an embodiment;
FIG. 7 illustrates a method in which a second capacitor component and a first inductor act as different components depending on a frequency band of a second RF signal according to an embodiment;
FIG. 8 illustrates a change in a second capacitor component and a first inductor depending on a frequency according to an embodiment;
FIG. 9 illustrates a method for linearizing a quadratic function representing impedance values of a second capacitor component and a first inductor depending on a frequency according to an embodiment;
FIG. 10A illustrates an operating frequency range according to a change in a gamma value when RF signals have a low power, according to an embodiment;
FIG. 10B illustrates an operating frequency range according to a change in a gamma value when RF signals have a high power, according to an embodiment;
FIG. 10C illustrates an operating frequency range according to a change in a gamma value when RF signals have a peak power, according to an embodiment;
FIG. 11 illustrates a method for separating a first capacitor component according to an embodiment;
FIG. 12 illustrates a method for determining a reference inductor for LC resonance of a first PAM according to an embodiment;
FIG. 13 illustrates T-type conversion and addition of a third capacitor for direct current (DC) prevention according to an embodiment; and
FIG. 14 illustrates graphs for when there is no first capacitor and a case where a first capacitor is connected between a first node and a first ground according to an embodiment.

[Best Mode]

Hereinafter, embodiments of the disclosure will be described with reference to the accompanying drawings.

In the drawings, the same or similar elements are preferably denoted by the same or similar reference numerals. Detailed descriptions of known functions or configurations that may make the subject matter of the disclosure unclear will be omitted for the sake of clarity and conciseness.

Terms described below are terms defined in consideration of functions in the disclosure, which may vary according to intentions or customs of users and providers. Therefore, the definition should be made based on the content throughout this specification.

Some components are exaggerated, omitted, or schematically illustrated in the accompanying drawings. The size of each component does not fully reflect the actual size. In each drawing, the same reference numerals are given to the same or corresponding components.

Embodiments of the disclosure enable a constitution of the disclosure to be complete and are provided to fully inform the scope of the disclosure to those of ordinary skill in the art to which the disclosure pertains.

As beamforming technology is introduced in 5G (or new radio (NR)), an electronic device may be required to transmit a signal having a high peak to average power ratio (PAPR). To output a high PAPR at a designed resonant frequency, a PA module (PAM) may be required to include a matching circuit (or matching network) for impedance matching and/or a quarter-wave transmission line (QWTL) for impedance transformation.

The size of a PAM may increase in case that a matching circuit and/or a QWTL are included for impedance matching. In addition, when a lumped element (e.g., an inductor) included in the matching circuit is directly connected to ground for impedance matching, a frequency of a signal output from the PAM may differ from a designed or configured resonant frequency.

As such, there is a need in the art for a method and apparatus for decreasing the size of the PAM and for providing consistency between the resonant frequency and PAM output signal frequency, to improve on these deficiencies in the conventional art.

The disclosure has been made to address at least the above-mentioned problems and/or disadvantages and to provide at least the advantages described below.

Accordingly, an aspect of the disclosure is to provide an electronic device that can reduce or minimize the size of a PAM.

An aspect of the disclosure is to provide an electronic device that can secure a relatively wide operating frequency band of the PAM.

FIG. 1 illustrates a wireless communication system according to an embodiment.

Referring to FIG. 1, the wireless communication system includes a base station 110, a terminal 120, and a terminal 130 as some of nodes using a wireless channel. Although FIG. 1 illustrates only one base station 110, additional base stations may also be included.

The base station 110 is a network infrastructure that provides wireless access to the terminals 120 and 130. The base station 110 has coverage defined as a certain geographical area, based on a distance over which a signal can be transmitted. The base station 110 may be referred to as an access point (AP), an eNodeB (eNB), a 5th generation node (5G node), a wireless point, a transmission/reception point (TRP), or another term having a technical meaning equivalent thereto, in addition to a base station.

Each of the terminal 120 and terminal 130 is used by a user and may communicate with the base station 110 through a wireless channel. In some cases, at least one of the terminal 120 and the terminal 130 may be operated without user involvement. That is, at least one of the terminal 120 and the terminal 130 performs machine type communication (MTC) and may not be carried by a user. Each of the terminal 120 and the terminal 130 may be referred to as a user equipment (UE), a mobile station, a subscriber station, a customer premises equipment (CPE), a remote terminal, a wireless terminal, an electronic device, a user device, or another term having a technical meaning equivalent thereto, in addition to a terminal.

The base station 110, the terminal 120, and/or the terminal 130 may transmit and receive a wireless signal in an mmWave band (e.g., 28 GHz, 30 GHz, 38 GHz, or 60 GHz). In this case, to improve a channel gain, the base station 110, the terminal 120, and/or the terminal 130 may perform transmission beamforming and reception beamforming. That is, the base station 110, the terminal 120, and the terminal 130 may give directivity to a transmission signal or a reception signal. To this end, the base station 110 and the terminals 120 and 130 may select serving beams 112, 113, 121, and 131 through a beam search or beam management procedure. After the serving beams 112, 113, 121, and 131 are selected, subsequent communication may be performed through a resource having a quasi co-located (QCL) relationship with a resource having transmitted the serving beams 112, 113, 121, and 131.

FIG. 2 illustrates an electronic device according to an embodiment.

Referring to FIG. 2, a functional configuration of an electronic device 210 is provided. The electronic device 210 includes an antenna unit 211, a filter unit 212, an RF processing unit 213, and/or a processor (i.e., controller) 214.

The antenna unit 211 may include a plurality of antennas (or antenna elements). The antennas perform functions for transmitting or receiving a signal through a wireless channel. The antennas may include a radiator formed of a conductor or a conductive pattern formed on a substrate (e.g., a PCB). The antennas may radiate an up-converted signal through a wireless channel or obtain a signal radiated by another device. Each of the antennas may be referred to as an antenna element or an antenna device. The antenna unit 211 may include an antenna array (e.g., a sub array) in which a plurality of antenna elements forms an array. The antenna unit 211 may be electrically connected to the filter unit 212 through RF signal lines and may be mounted on a PCB including a plurality of antenna elements. The PCB may include a plurality of RF signal lines which connect each antenna element to a filter of the filter unit 212. Such RF signal lines may be referred to as a feeding network. The antenna unit 211 may provide a received signal to the filter unit 212 or may radiate a signal provided from the filter unit 212 into the air. The disclosed antennas may be included in the antenna unit 211.

The antenna unit 211 may include at least one antenna module having a dual-polarized antenna, such as a cross-pole (x-pol) antenna and may include two antenna elements corresponding to different polarizations. For example, the dual-polarized antenna may include a first antenna element having a polarization of +45° and a second antenna element having a polarization of -45°. The polarization may be formed by other orthogonal polarizations in addition to +45° and -45°. Each of the antenna elements may be connected to a feeding line and may be electrically connected to the filter unit 212, the RF processing unit 213, and/or the controller 214 described below.

The dual-polarized antenna may be a patch antenna (or a microstrip antenna) and thus may be easily implemented and integrated into an array antenna. Two signals having different polarizations may be input to each antenna port corresponding to an antenna element. For high efficiency, it is required to optimize a relationship between co-pol characteristics and cross-pol characteristics between the two signals having different polarizations. In the dual-polarized antenna, the co-pol characteristics represent characteristics for a specific polarization component, and the cross-pol characteristics represent characteristics for the specific polarization component and other polarization components.

An antenna (e.g., an antenna element, a sub array, or an antenna array) of an antenna device including a separate type PCB may be included in the antenna unit 211. For example, a first conductive member or a second conductive member of the antenna device may refer to an antenna element and may be included in the antenna unit 211 of FIG. 2.

The filter unit 212 may perform filtering to transmit a signal of a desired frequency. The filter unit 212 may perform a function for selectively identifying a frequency by forming a resonance. The filter unit 212 may form a resonance through a cavity which structurally includes a dielectric. In addition, the filter unit 212 may form a resonance through devices which form inductance or capacitance. In addition, the filter unit 212 may include an elastic filter, such as a bulk acoustic wave (BAW) filter or a surface acoustic wave (SAW) filter. The filter unit 212 may include at least one of a band pass filter, a low pass filter, a high pass filter, or a band reject filter. That is, the filter unit 212 may include RF circuits for obtaining a signal of a frequency band for transmission or a frequency band for reception. The filter unit 212 may electrically connect the antenna unit 211 and the RF processing unit 213.

The RF processing unit 213 may include a plurality of RF paths. An RF path may be the unit of a path through which a signal received through an antenna or a signal radiated through an antenna passes. At least one RF path may be referred to as an RF chain including a plurality of RF devices, such as an amplifier, a mixer, an oscillator, a digital-to-analog converter (DAC), an analog-to-digital converter (ADC), etc. For example, the RF processing unit 213 may include an up converter which up-converts a digital transmission signal in a baseband to a transmission frequency, and a DAC which converts an up-converted digital transmission signal into an analog RF transmission signal. The up converter and the DAC form a part of a transmission path. The transmission path may further include a PA or a coupler (or combiner). The RF processing unit 213 may include an ADC which converts an analog RF reception signal into a digital reception signal, and a down converter which converts a digital reception signal into a digital reception signal in a baseband. The ADC and the down converter form a part of a reception path. The reception path may further include a low-noise amplifier (LNA) or a coupler (or divider). RF components of the RF processing unit may be implemented on a PCB. The antennas and the RF components of the RF processing unit may be implemented on the PCB, and filters may be repeatedly connected between PCBs to form multiple layers.

An RFIC and a package board (PKG) of the antenna device including the separate type PCB according to an embodiment of the disclosure may be included in the RF processing unit 213 of FIG. 2. That is, the RF processing unit 213 may include the RFIC as an RF device for mmWave. As described above, the RFIC may be formed as an RFIC chip coupled with the PKG, to be coupled to a first PCB, or the RFIC may be directly coupled by the first PCB.

The controller 214 may control the overall operations of the electronic device 210. The controller 214 may include various modules for performing communication. The controller 214 may include at least one processor such as a modem. The controller 214 may include modules for digital signal processing. For example, the controller 214 may include a modem. When data transmission, the controller 214 generates complex symbols by encoding and modulating transmission bit streams. When data reception, the controller 214 restores a reception bit stream through demodulation and decoding of a baseband signal. The controller 214 may perform functions of a protocol stack required by communication standards.

FIG. 3 illustrates an electronic device according to an embodiment.

Referring to FIG. 3, an electronic device 301 includes at least one processor 310, at least one transceiver 320, and/or at least one antenna 330.

The electronic device 301 may be at least one of the base station 110, the terminal 120, or the terminal 130 of FIG.

1.

The at least one processor 310 may include at least one communication processor. The at least one processor 310 may be electrically connected to the at least one transceiver 320 and may generate or process a signal (e.g., a baseband signal).

For example, the at least one processor 310 may transmit a signal (e.g., a baseband signal) to the at least one transceiver 320 or receive a signal (e.g., a baseband signal) from the at least one transceiver 320.

The at least one transceiver 320 may be electrically connected to the at least one antenna 330. The at least one transceiver 320 may up-convert an intermediate frequency (IF) signal transmitted from the at least one processor 310 to an RF signal and transmit the RF signal to the at least one antenna 330.

In another example, the at least one transceiver 320 may receive an RF signal from the at least one antenna 330, down-convert the RF signal to an IF signal, and transmit the IF signal to the at least one processor 310.

The at least one transceiver 320 may include at least one transmitter and/or at least one receiver. For example, the at least one transceiver 320 may include a first transceiver including a first transmitter and a first receiver, and the at least one transceiver 320 may include a second transceiver including the first transmitter.

The at least one transceiver 320 may process, transmit, and/or receive RF signals in various frequency bands. For example, each of the first transceiver and the second transceiver included in the at least one transceiver 320 may process an RF signal in a first frequency band.

For example, the first transceiver included in the at least one transceiver 320 may process an RF signal in the first frequency band, and the second transceiver may process an RF signal in a second frequency band. The second frequency band may partially overlap with the first frequency band.

The at least one antenna 330 may include various types of antennas. For example, the at least one antenna 330 may include a patch antenna, a dipole antenna, a monopole antenna, a slit antenna, a laser direct structuring (LDS) antenna, and/or an inverted-F antenna (IFA).

For example, the at least one antenna 330 may include an antenna for transmitting and/or receiving a signal in an mmWave frequency band. For example, the at least one antenna 330 may include a plurality of antenna elements (e.g., a patch antenna), and the plurality of antenna elements may form an array. The plurality of antenna elements forming the array may transmit and/or receive a signal in the mmWave frequency band.

The term "at least one processor 310" in the disclosure may be replaced with another term referring to a configuration for data processing. For example, the term "at least one processor" may be replaced with a controller or a computing device.

The at least one transceiver 320 may include an RFIC and/or an IF integrated circuit (IFIC). For example, in FIG. 3, the at least one transceiver 320 is described as including an RFIC and an IFIC, but this is only an example, and the at least one transceiver 320 may correspond to an RFIC. As another example, the at least one transceiver 320 may correspond to an IFIC.

FIG. 4 illustrates at least one antenna and at least one transceiver according to an embodiment.

Referring to FIG. 4, the electronic device 301 may include the at least one transceiver 320 and/or the at least one antenna 330.

The at least one antenna 330 may include at least one antenna element 401. For example, the at least one antenna element 401 may include a (1-1)th antenna element 411-1, a (1-2)th antenna element 411-2, ..., an (N-1)th antenna element 41N-1, ..., and an (N-M)th antenna element 41N-M.

For example, the at least one antenna element 401 may include antenna elements forming N rows and M columns (or N x M). In an example, the (1-1)th antenna element 411-1, the (1-2)th antenna element 411-2, ..., and a (1-M)th antenna element 411-M may form a first row.

In an example, a (2-1)th antenna element 412-1, ..., and a (2-M)th antenna element 412-M may form a second row. The (N-1)th antenna element 41N-1, ..., and the (N-M)th antenna element 41N-M may form a Nth row.

The at least one transceiver 320 may include an RF-front end module (RF-FEM) 410 and/or an RFIC 420. For example, the RF-FEM 410 may electrically connect the (1-1)th antenna element 411-1 and the RFIC 420. For example, the RF-FEM 410 may amplify RF signals received from the RFIC 420 and may transmit the amplified signals to the (1-1)th antenna element 411-1, or amplify RF signals received from the (1-1)th antenna element 411-1 and transmit the amplified signals to the RFIC 420.

The RF-FEM 410 may include a first PAM 421, a second PAM 422, a first LNA 425, a second LNA 426, a first circulator 431, a second circulator 432, a first switch 433, and/or a second switch 434.

The first PAM 421 may amplify first polarized signals received from the RFIC 420 and transmit the amplified first polarized signals to the (1-1)th antenna element 411-1 through the first circulator 431. The first LNA 425 may amplify first polarized signals received through the (1-1)th antenna element 411-1 and the first circulator 431, and transmit the amplified first polarized signals to the RFIC 420. For example, the first PAM 421 may include a Doherty PA.

The second PAM 422 may amplify second polarized signals received from the RFIC 420 and transmit the amplified second polarized signals to the (1-1)th antenna element 411-1 through the second circulator 432. The second LNA 426 may amplify second polarized signals received through the (1-1)th antenna element 411-1 and the second circulator 432, and transmit the amplified second polarized signals to the RFIC 420. For example, the second PAM 422 may include a Doherty PA.

A first polarized signal and a second polarized signal may have a polarization angle difference of about 90 degrees from each other. For example, the first polarized signal may have a horizontal polarization, and the second polarized signal may have a vertical polarization. For example, the first polarized signal may have a vertical polarization, and the second polarized signal may have a horizontal polarization.

For example, the first polarized signal may have a polarization of about +45 degrees, and the second polarized signal may have a polarization of about -45 degrees.

The first PAM 421 and the first LNA 425 may be components for or dedicated to the first polarized signal. As another example, the second PAM 422 and the second LNA 426 may be components for or dedicated to the second polarized signal.

The first switch 433 may selectively connect the first circulator 431 to the first LNA 425 or to ground within the electronic device 301. For example, the first switch 433 may electrically connect the first circulator 431 and the first LNA 425 when receiving first polarized signals through the (1-1)th antenna element 411-1. The first switch 433 may electrically connect the first circulator 431 and the ground when transmitting first polarized signals through the (1-1)th antenna element 411-1.

The second switch 434 may selectively connect the second circulator 432 to the second LNA 426 or to the ground within the electronic device 301. For example, the second switch 434 may electrically connect the second circulator 432 and the second LNA 426 when receiving second polarized signals through the (1-1)th antenna element 411-1. The second switch 434 may electrically connect the second circulator 432 and the ground when transmitting second polarized signals through the (1-1)th antenna element 411-1.

The RFIC 420 may include a mixer for generating RF signals in a specified frequency band and/or a phase shifter for controlling the phase of RF signals.

In the antenna elements forming N rows and M columns according to the disclosure, N may be an integer greater than or equal to 1, and M may be an integer greater than or equal to 1. That is, there may be one or more antenna elements forming N rows and M columns.

In FIG. 4, the at least one antenna element 401 is described as having a conductive patch shape, but this is only an example. For example, the at least one antenna element 401 may include various types of antennas (e.g., an IFA, an LDS antenna, or a slit antenna).

In FIG. 4, the RF-FEM 410 and the RFIC 420 are described as separate configurations, but this is only an example. For example, the RF-FEM 410 and the RFIC 420 may be one configuration. For example, the entire RF-FEM 410 and RFIC 420 may also be referred to as an RFIC.

Hereinafter, in FIG. 5, components and operations of the first PAM 421 electrically connected to the (1-1)th antenna element 411-1 are described.

FIGs. 5 to 14 will be described based on the configurations (or electronic components) included in the first PAM 421 and the operations performed by the first PAM 421, but may also be applied to the second PAM 422 or another PAM.

FIG. 5 illustrates an RFIC and a first PAM according to an embodiment.

Referring to FIG. 5, the RFIC 420 includes a mixer 510 and/or a distributor 520. The first PAM 421 includes a first transistor 531, a second transistor 532, a connection line 580, a resistor 573, and/or a circuit 572 for impedance matching.

The connection line 580 includes a first connection line 581, a second connection line 582, a third connection line 583, and/or a fourth connection line 584. For example, the connection line 580 may be at least one of a microstrip line, a bond wire, or a conductive via of a PCB.

The mixer 510 of the RFIC 420 may generate signals in a specified frequency band. In another example, the mixer 510 may convert a signal received from a communication processor or an IFIC into signals in a specified frequency band.

The mixer 510 may transmit signals in a specified frequency band to the distributor 520. The distributor 520 may divide a signal received from the mixer 510 and transmit the divided signal to the first transistor 531 and the second transistor 532.

For example, the mixer 510 may transmit a signal in a specified frequency band to the distributor 520. The distributor 520 may divide the received signal into a first signal and a second signal, transmit the first signal to the first transistor 531, and transmit or distribute the second signal to the second transistor 532.

The first transistor 531 may include a first capacitor 541. For example, the first capacitor 541 may have a first capacitance value (e.g., $C_{out.p}$).

When the first signal received from the distributor 520 is greater than or equal to a specified voltage, the first transistor 531 (e.g., a peaking transistor) may amplify the first signal into a first RF signal. For example, the first transistor 531 may not operate when the first signal received from the distributor 520 is less than a preconfigured threshold value. In this case, the first transistor 531 may not output the amplified signal. In another example, when the first signal received from the distributor 520 is greater than or equal to the preconfigured threshold value, the first transistor 531 may amplify the first signal into the first RF signal. In this case, the first transistor 531 may output the amplified first RF signal.

Herein, the operation of a PAM may be understood as amplifying of a received signal and transmitting of the amplified signal through a connection line (e.g., the first connection line 581) by the PAM.

The first transistor 531 may be electrically connected to a first ground 561.

The second transistor 532 may include a second capacitor 542. For example, the second capacitor 542 may have a second capacitance value (e.g., $C_{out.c}$). For example, the second capacitance value of the second capacitor 542 may be substantially the same as the first capacitance value of the first capacitor 541. In another example, the second capacitance value of the second capacitor 542 may be different from the first capacitance value of the first capacitor 541.

The second transistor 532 (e.g., a carrier transistor) may amplify the second signal received from the distributor 520 into a second RF signal. For example, the second transistor 532 may amplify the second signal into the second RF signal, based on the reception of the second signal, regardless of a voltage value of the second signal.

The second transistor 532 may be electrically connected to a second ground 562. For example, the second ground 562 may be substantially the same as the first ground 561. In another example, the second ground 562 may be different from the first ground 561.

The first transistor 531 may be electrically connected to the first connection line 581, and the second transistor 532 may be electrically connected to the second connection line 582.

For example, the first connection line 581 may be a line through which the first RF signal output from the first transistor 531 is transmitted. The first connection line 581 may be referred to as an electrical path from the first transistor 531 to a first node 591.

For example, the second connection line 582 may be a line through which the second RF signal output from the second transistor 532 is transmitted. The second connection line 582 may be referred to as an electrical path from the second transistor 532 to the first node 591.

The first connection line 581 and the second connection line 582 may be connected or coupled at the first node 591. As another example, the first connection line 581 and the second connection line 582 may be combined at the first node 591.

The third connection line 583 may electrically connect the first node 591 and the at least one antenna 330 (e.g., the (1-1)th antenna element 411-1). For example, the third connection line 583 may be a path from the first node 591 to the at least one antenna 330.

The fourth connection line 584 may be connected to the third connection line 583 at a third node 593.

As the first connection line 581 and the second connection line 582 are connected at the first node 591, a first signal and a second signal output from different transistors may be transmitted to the at least one antenna 330. For example, a first signal output from the first transistor 531 may be transmitted to the third connection line 583 through the first connection line 581 and the first node 591. A second signal output from the second transistor 532 may be transmitted to the third connection line 583 through the second connection line 582 and the first node 591. Each of the first signal and the second signal transmitted to the third connection line 583 may be transmitted to the at least one antenna 330.

The first PAM 421 may include a first inductor 551 and/or a third capacitor 543. For example, the first inductor 551 may be electrically connected to the first node 591 of the connection line 580. For example, the third capacitor 543 may be electrically connected to the first node 591 through the first inductor 551.

For another example, the first inductor 551 and the third capacitor 543 may electrically connect a third ground 563 and the first node 591 of the connection line 580. For example, the third ground 563 may be substantially the same as the first ground 561 and/or the second ground 562.

The first PAM 421 may expand an operating frequency band of the first transistor 531, based on the first inductor 551 and the third capacitor 543. For example, in a case that the first inductor 551 and the third capacitor 543 are disposed between the first node 591 and the third ground 563, when a frequency of a first RF signal output from the first transistor 531 is less than a designed resonant frequency w0, the first inductor 551 and the third capacitor 543 may act as an inductor. In addition, when the frequency of the first RF signal output from the first transistor 531 is greater than the designed resonant frequency w0, the first inductor 551 and the third capacitor 543 may act as a capacitor. In this case, as described later in relation to FIG. 10, the first PAM 421 may secure a relatively wide resonant frequency band (e.g., a specified frequency) of a first signal.

The second connection line 582 may include a second inductor 552 and/or a third inductor 553. For example, the second inductor 552 and the third inductor 553 may be arranged between the second transistor 532 and the first node 591. For example, the second inductor 552 and the third inductor 553 may be connected in series to the second transistor 532. For example, the second inductor 552 may connect the second transistor 532 and the third inductor 553, and the third inductor 553 may connect the second inductor 552 and the first node 591.

The second inductor 552 may be connected to the second transistor 532 to attenuate a capacitance value of the second capacitor 542. The third inductor 553 may be connected to the first node 591 to attenuate a capacitance value of the first capacitor 541.

Each of the second inductor 552 and the third inductor 553 may be electrically connected to the third ground 563 through the first inductor 551 and the third capacitor 543.

A fourth inductor 554 may be connected to the second connection line 582 at a second node 592. For example, the fourth inductor 554 may be electrically connected to the second connection line 582 at the second node 592 between the second inductor 552 and the third inductor 553. For example, the fourth inductor 554 may be connected in parallel with the second connection line 582.

The fourth inductor 554 may be electrically connected to a power supply source 571 (e.g., a battery). For example, the electronic device 301 may include the power supply source 571, and the power supply source 571 may provide power to drive the first transistor 531 and the second transistor 532.

The power supply source 571 may supply power to the second transistor 532 to drive the second transistor 532 through the fourth inductor 554 and a part (e.g., the second inductor 552) of the second connection line 582. The power supply source 571 may supply power to the first transistor 531 to drive the first transistor 531 through the fourth inductor 554 and a part (e.g., the third inductor 553) of the second connection line 582.

For example, power supplied by the power supply source 571 may be direct current (DC) power.

The first connection line 581 and the second connection line 582 may be transmission paths for a first RF signal output from the first transistor 531 and a second RF signal output from the second transistor 532, as well as feeding paths for supplying a DC to the first transistor 531 and the second transistor 532, respectively.

The size of the first PAM 421 may be relatively reduced as the second inductor 552, the third inductor 553, and the fourth inductor 554 are arranged between the second transistor 532 and the first node 591. For example, when a separate matching circuit (or matching network) for attenuating the second capacitor 542 is included in the first PAM 421 instead of the second inductor 552, the third inductor 553, and the fourth inductor 554, the size of the first PAM 421 may be increased. As a result, the size of the first PAM 421 may be reduced or minimized by including the second inductor 552, the third inductor 553, and the fourth inductor 554 instead of the separate matching circuit.

The first PAM 421 may reduce a change in a resonant frequency caused by inductors as the second inductor 552, the third inductor 553, and the fourth inductor 554 are disposed between the second transistor 532 and the first node 591.

For example, it may be assumed that the second inductor 552, the third inductor 553, and the fourth inductor 554 are not arranged between the second transistor 532 and the first node 591, and the second inductor 552, the third inductor 553, and the fourth inductor 554 are directly connected to a ground (e.g., the third ground 563). In this case, the second inductor 552, the third inductor 553, and the fourth inductor 554 may change impedance of the first PAM 421, thereby changing a resonant frequency of RF signals output from the first PAM 421, and the performance of the first PAM 421 may deteriorate. However, when the second inductor 552, the third inductor 553, and the fourth inductor 554 are electrically connected to the third ground 563 through the first inductor 551 and the third capacitor 543, a change in the impedance of the first PAM 421 may be reduced or minimized.

As a result, the first PAM 421 may reduce or minimize the deterioration of the performance of the first PAM 421 through the second inductor 552, the third inductor 553, and the fourth inductor 554 arranged between the second transistor 532 and the first node 591.

The third connection line 583 may include a circuit 572 for impedance matching. For example, the circuit 572 may include at least one lumped element (e.g., a capacitor and an inductor). In this case, the circuit 572 may adjust impedance of the third connection line 583.

The fourth connection line 584 may include a resistor 573 for impedance matching. For example, the resistor 573 may have a value of about 50 ohms. The fourth connection line 584 may electrically connect the third connection line 583 and a fourth ground 564.

A specified frequency band of a first RF signal output by the first transistor 531 may be determined based on a first part 521 of the first PAM 421. For example, the first part 521 may include the first capacitor 541, the first inductor 551, and the third capacitor 543. A resonant frequency of a first RF signal output by the first transistor 531 may be determined based on capacitor values of the first capacitor 541 and the third capacitor 543 and an inductance value of the first inductor 551.

In another example, the sum of impedances (or the sum of reactance) of the first inductor 551, the first capacitor 541, and the third capacitor 543 may be configured such that a first RF signal output from the first transistor 531 and a second RF signal output from the second transistor 532 resonate in a specified frequency band (or a resonant frequency). For another example, the sum of impedances of the first inductor 551, the first capacitor 541, and the third capacitor 543 may correspond to the specified frequency band (or the resonant frequency).

A second part 522 of the first PAM 421 may be a part for converting or matching impedance of the first part 521 with reference to the first transistor 531. For example, the second part 522 may include the first capacitor 541, the second capacitor 542, the second inductor 552, the third inductor 553, and/or the fourth inductor 554.

The electronic device 301 may further include a phase compensator which connects the first transistor 531 and the distributor 520. In this case, the phase compensator may be configured to control a phase of a first signal input to the first transistor 531 such that the phase of the first signal and a phase of a second signal input to the second transistor 532 have a difference corresponding to as a specified value.

Herein, it has been described that the fourth inductor 554 is connected to the second connection line 582, but this is only an example. For example, the second connection line 582 may also be described as including the fourth inductor 554. In this case, the second connection line 582 may have a T-shape and may be connected to the power supply source 571. However, the second connection line 582 may have various shapes and is not limited to a T-shape.

Herein, connection line of the disclosure may be replaced with conductive line, conductive path, or electrical path.

The first part 521 of the first PAM 421 of the disclosure may be replaced with LC resonant unit, LC resonator, or resonant unit.

The second part 522 may be replaced with QWTL unit, impedance part, or impedance matching unit.

The circuit 572 for impedance matching in FIG. 5 is described as adjusting impedance of the third connection line 583, but this is only an example. For example, the circuit 572 may also be referred to as a configuration of adjusting impedance of an output terminal of the first PAM 421.

In FIG. 5, the first ground 561, the second ground 562, the third ground 563, and the fourth ground 564 are described as separate configurations, but this is only an example. For example, at least two of the first ground 561, the second ground 562, the third ground 563, or the fourth ground 564 may be substantially the same. The first ground 561 may be the same as the second ground 562. The third ground 563 may be the same as the fourth ground 564.

In FIG. 5, the first PAM 421 and the first LNA 425 have been described as separate configurations, but this is only an example. For example, the first PAM 421 and the first LNA 425 may also be described as being included within one module or circuit.

FIG. 6 illustrates a first PAM implemented on a PCB and a plurality of chips according to an embodiment.

Referring to FIG. 6, the first PAM 421 may include a first chip 610, a second chip 620, and/or a PCB 630. For example, the first chip 610 may be a first die, and the second chip 620 may be a second die.

The first chip 610 may include the first transistor 531. For example, the first transistor 531 may be implemented in the first chip 610.

The first transistor 531 implemented in the first chip 610 may be electrically connected to the first ground 561 through first connection members 621.

The second chip 620 may include the second transistor 532. For example, the second transistor 532 may be implemented in the second chip 620.

The second transistor 532 implemented in the second chip 620 may be electrically connected to the second ground 562 through second connection members 622.

The PCB 630 may include a conductive line 650. For example, the conductive line 650 may include a first part 651, a second part 652, and/or a third part 653.

The first part 651 may be electrically connected to the first transistor 531 through a first connection member 641. The first part 651 may include the first inductor 551 and/or the third capacitor 543, and the first part 651 may be electrically connected to the third ground 563.

The second part 652 may be electrically connected to the first transistor 531 through a third connection member 643 and/or a fourth connection member 644. The second part 652 may be electrically connected to the second transistor 532 through a fifth connection member 645 and/or a sixth connection member 646. The second part 652 may be electrically connected to the power supply source 571. The second part 652 may include the second inductor 552, the third inductor 553, and/or the fourth inductor 554.

The third part 653 may be electrically connected to the first transistor 531 through a second connection member 642, and the third part 653 may be electrically connected to the third connection line 583.

In FIG. 6, it has been described that the first transistor 531 and the second transistor 532 of the first PAM 421 are implemented as separate chips, but this is only an example. For example, the first transistor 531 and the second transistor 532 may be implemented as one chip.

It has also been described that the first transistor 531 and the second transistor 532 of the first PAM 421 are implemented as separate chips, and inductors and capacitors are arranged on the PCB 630, but this is only an example. For example, the first chip 610, the second chip 620, and the PCB 630 may be configured as one substrate.

In addition, it has been described that the first PAM 421 includes the PCB 630, and inductors (e.g., the first inductor 551) and/or capacitors (e.g., the third capacitor 543) are arranged on the PCB 630, but this is only an example. For example, the inductors and/or the capacitors may be arranged or implemented on the first chip 610 or the second chip 620. In another example, the first PAM 421 may include a flexible PCB (FPCB), and the inductors and/or the capacitors may be arranged or implemented on the FPCB.

In FIG. 6 of the disclosure, the arrangement of the connection line 580 of FIG. 5 is not described, but this is omitted for convenience of description. For example, the first connection line 581 and the second connection line 582 may be disposed on or within the PCB 630.

FIG. 7 illustrates a method in which a second capacitor component and a first inductor act as different components depending on a frequency band of a second RF signal according to an embodiment.

Referring to FIG. 7, the first PAM 421 may include a QWTL 710, and the QWTL 710 may electrically connect the second transistor 532 and the first node 591. For example, the QWTL 710 may include the second inductor 552, the third inductor 553, and the fourth inductor 554 of FIG. 5.

The first transistor 531 may include a first current source 731, and the second transistor 532 may include a second current source 732.

The first capacitor 541 may be divided into a first capacitor component 721 (e.g., $C_{QWTL}$) and a second capacitor component 722 (e.g., $C_R$). For example, the first capacitor 541 may be divided into the first capacitor component 721 and the second capacitor component 722 connected in parallel to each other. For example, a first capacitance value of the first capacitor 541 may be the sum of a capacitance value of the first capacitor component 721 and a capacitance value of the second capacitor component 722, the first and second capacitor components being connected in parallel to each other.

The first capacitor component 721 (e.g., $C_{QWTL}$) may be included in the first transistor 531. The second capacitor component 722 may be electrically connected to the first node 591. For example, the second capacitor component 722 may be disposed between the first node 591 and the third ground 563, and the first node 591 of the connection line 580 and the third ground 563 may be electrically connected through the second capacitor component 722.

The first PAM 421 may include a first inductor 723 (e.g., $L_R$), and the first inductor 723 may be electrically connected to the first node 591. For example, the first inductor 723 may be disposed between the first node 591 and the third ground 563, and the first node 591 of the connection line 580 and the third ground 563 may be electrically connected through the first inductor 723.

The first inductor 723 may substantially correspond to the first inductor 551 of FIG. 5. For example, when the third capacitor 543 is added between the first inductor 723 and the third ground 563 as described below in relation to FIG. 13, an inductance value of the first inductor 723 may differ by a predetermined magnitude from an inductance value of the first inductor 551 of FIG. 5. However, the first inductor 723 may substantially correspond to the first inductor 551 of FIG. 5.

The second capacitor component 722 and the first inductor 723 may be connected in parallel to the first node 591 where the first connection line 581 and the second connection line 582 meet.

The second capacitor component 722 and the first inductor 723 may correspond to different lumped elements according to a resonant frequency of an RF signal output from the first PAM 421.

Equation (1) below is given for impedance (or reactance) values of the second capacitor component 722 and the first inductor 723 connected in parallel to each other. In Equation (1), w may be a resonance frequency (or an actual resonance frequency) of RF signals output from the first PAM 421, $C_R$ may be a capacitance value of the second capacitor component 722, and $L_R$ may be an inductance value of the first inductor 723.

$$jB(w) = -j\frac{w^2 C_R L_R - 1}{w L_R} \quad \ldots(1)$$

Equation (2) below is given for a resonant frequency (or a designed resonant frequency) of the first PAM 421 determined based on the second capacitor component 722 and the first inductor 723 connected in parallel to each other.

$$w_0 = \sqrt{C_R L_R} \quad \ldots(2)$$

In Equation (2), $w_0$ may be a designed or configured resonant frequency of the first PAM, $C_R$ may be a capacitance value of the second capacitor component 722, and $L_R$ may be an inductance value of the first inductor 723.

The first PAM 421 may be designed to output RF signals having a frequency of $w_0$, but RF signals actually output from the first PAM 421 may have a frequency (or an actual frequency) of w. For example, $w_0$ may be a target resonant frequency, a designed resonant frequency, or a configured resonant frequency. For example, w may be a resonant frequency of an actual output RF signal.

Referring back to Equation (1), when w is substantially equal to $w_0$, the sum of impedances (or the sum of reactance) of the second capacitor component 722 and the first inductor 723 may be 0. For example, when w is less than $w_0$, the sum of impedances (or the sum of reactance) of the second capacitor component 722 and the first inductor 723 may be less than 0. In this case, the second capacitor component 722 and the first inductor 723 may correspond to an inductor. For example, when w is greater than $w_0$, the sum of impedances (or the sum of reactance) of the second capacitor component 722 and the first inductor 723 may be greater than 0. In this case, the second capacitor component 722 and the first inductor 723 may correspond to a capacitor.

That is, based on a difference in magnitude between a resonant frequency w of an RF signal actually output from the first PAM 421 and a resonant frequency $w_0$ of an RF signal that the first PAM 421 is configured to output, the second capacitor component 722 and the first inductor 723 may operate or act as different lumped elements.

As the second capacitor component 722 and the first inductor 723 are seen, operate, or act as different lumped elements depending on a resonant frequency w of an actual output RF signal, the first PAM 421 may expand a resonant frequency band (or an operating frequency band) of RF signals output from the first PAM 421.

For example, when the second capacitor component 722 and the first inductor 723 are not connected to the first node 591, a range of a frequency band having a specified antenna radiation efficiency (e.g., a radiation efficiency having a value within 1 dB with reference to the radiation efficiency in a resonant frequency band) within a specified frequency band may be a first range. However, when the second capacitor component 722 and the first inductor 723 are connected to the first node 591, a range of a frequency band having a specified radiation efficiency may be a second range that is larger than the first range. As a result, as the second capacitor component 722 and the first inductor 723 are arranged between the first node 591 and the third ground 563, the first PAM 421 may expand a resonant frequency band (or an operating frequency band).

The expansion of a resonant frequency based on the second capacitor component 722 and the first inductor 723 is described in detail below in relation to FIGS. 10A to 10C.

The description has been made in FIG. 7 using the second capacitor component 722 and the first inductor 723, but this is only an example. The first capacitor component 721 and the second capacitor component 722 may be understood as substantially corresponding to the first capacitor 541, and the first ground 561 and the third ground 563 may be understood to be substantially the same. Therefore, a structure in which the second capacitor component 722 and the first inductor 723 are connected to the first node 591 may be substantially the same as a structure in which the first capacitor 541 and the first inductor 551 of FIG. 5 are connected to the first node 591.

As a result, as the first capacitor 541 and the first inductor 551 are connected between the first node 591 and a ground (e.g., the first ground 561 or the third ground 563), the first PAM 421 may expand a resonant frequency band (or an operating frequency band). That is, to the description in FIG. 7 of the second capacitor component 722 and the first inductor 723 acting as different lumped elements depending on the frequency of an output RF signal may also be substantially applied to the first capacitor 541 and the first inductor 551 of FIG. 5Furthermore, the above description, with reference to FIG. 7 of the disclosure, of the second capacitor component 722 and the first inductor 723 acting as different lumped elements depending on the frequency of an output RF signal may also be substantially applied to the first capacitor 541, the third capacitor 543, and the first inductor 551 of FIG. 5.

FIG. 8 illustrates a change in a second capacitor component and a first inductor depending on a frequency according to an embodiment.

Referring to FIG. 8, Equation (3) below is given for a quality factor Q.

$$Q = (\text{reactance})/(\text{resistance value}) \quad \ldots(3)$$

The larger the capacitance value of the second capacitor component 722, the smaller the Q value, and the smaller the inductance value of the first inductor 551, the smaller the Q value.

A first graph 811 may be for an impedance value (or a reactance value) according to a frequency when a Q value of the second capacitor component 722 and the first inductor 551 is a first value. A second graph 812 may be for an impedance value (or a reactance value) according to a frequency when a Q value of the second capacitor component 722 and the first inductor 551 is a second value less than the first value. A third graph 813 may be for an impedance value (or a reactance value) according to a frequency when a Q value of the second capacitor component 722 and the first inductor 551 is a third value less than the second value.

For example, the first graph 811, the second graph 812, and the third graph 813 may be derived from Equation (1) expressed as a quadratic function for a resonant frequency w. That is, the first graph 811, the second graph 812, and the third graph 813 illustrated in FIG. 8 may be understood as a part of the quadratic function for the resonant frequency w.

The slopes of the first graph 811, the second graph 812, and the third graph 813 may vary depending on impedance values (or reactance values) of the second capacitor component 722 and the first inductor 551.

When the Q value is small than when the Q value is large, a wider operating frequency band may be secured when the intensity of RF signals output by the first PAM 421 corresponds to a low power.

FIG. 9 illustrates a method for linearizing a quadratic function representing impedance values of a second capacitor component and a first inductor depending on a frequency according to an embodiment.

Referring to FIG. 9, a first graph 911 represents impedance values (or reactance values) of the second capacitor component 722 and the first inductor 551 according to a frequency based on Equation (1).

A second graph 912 is obtained by linearizing the first graph 911. For example, the second graph 912 may be represented as in Equation (4) below.

$$jB(w) = j\gamma(w - w_0) \quad \ldots(4)$$

In Equation (4), the sum of impedances (or reactance) of the second capacitor component 722 and the first inductor 551 according to a frequency is expressed as a linear function graph with gamma y as a coefficient.

Hereinafter, in FIGS. 10A and 10B, it is described that a range of an operating frequency band is changed according to a change in a gamma y value.

FIG. 10A illustrates an operating frequency range according to a change in a gamma value when RF signals have a low power according to an embodiment.

Referring to FIG. 10A, a first Smith chart 1001 including curves having different gamma values when RF signals output from the first PAM 421 have a low power is illustrated.

For example, a first curve 1011 is an impedance curve of the second capacitor component 722 and the first inductor 551 when a gamma value is a first value (e.g., 0), a second curve 1012 is an impedance curve of the second capacitor component 722 and the first inductor 551 when a gamma value is a second value (e.g., 10^-13) greater than the first value, and a third curve 1013 is an impedance curve of the second capacitor component 722 and the first inductor 551 when a gamma value is a third value (e.g., 2*10^-13) greater than the second value. A fourth curve 1014 is an impedance curve of the second capacitor component 722 and the first inductor 551 when a gamma value is a fourth value (e.g., 3*10^-13) greater than the third value. A fifth curve 1015 is an impedance curve of the second capacitor component 722 and the first inductor 551 when a gamma value is a fifth value (e.g., 4* 10^-13) greater than the fourth value. A sixth curve 1016 is an impedance curve of the second capacitor component 722 and the first inductor 551 when a gamma value is a sixth value (e.g., 5*10^-13) greater than the fifth value.

A first range 1041 may be referred to as a range of impedance having a difference within about 1 dB with reference to a first point 1051 of the first chart 1001. For example, it may be said that the larger the portion of the graph included within the first range 1041, the wider the operating frequency band of the first PAM 421 is. For example, in a frequency band of about 2.1 to about 5.1 GHz, an operating frequency band of the first PAM 421 may correspond to a certain frequency band in which the antenna radiation efficiency is greater than or equal to a specified value (e.g., about 10 dB). The larger the portion of the graph included within the first range 1041, the wider the operating frequency band in which the antenna radiation efficiency is greater than or equal to the specified value is.

The larger the portion of the graph included within the first range 1041, the wider the operating frequency band of the first PAM 421 is. For example, compared to the first graph 1011, the second graph 1012 may have a larger portion included within the first range 1041. For example, the third graph 1013 may have a larger portion included within the first range 1041 compared to the second graph 1012. For example, the fourth graph 1014 may have a relatively larger portion included within the first range 1041 compared to the third graph 1013.

As a result, as the gamma value increases, the graph may have a larger portion included within the first range 1041, and when the RF signals have a low power, as the gamma value increases, the operating frequency band of the first PAM 421 may be widened.

FIG. 10B illustrates an operating frequency range according to a change in a gamma value when RF signals have a high power according to an embodiment.

Referring to FIG. 10B, a second Smith chart 1002 including curves having different gamma values when RF signals output from the first PAM 421 have a high power is illustrated.

A first curve 1021 is an impedance curve of the second capacitor component 722 and the first inductor 551 when a gamma value is a first value (e.g., 0), a second curve 1022 is an impedance curve of the second capacitor component 722 and the first inductor 551 when a gamma value is a second value (e.g., 10^-13) greater than the first value, and a third curve 1023 is an impedance curve of the second capacitor component 722 and the first inductor 551 when a gamma value is a third value (e.g., 2* 10^-13) greater than the second value. A fourth curve 1024 is an impedance curve of the second capacitor component 722 and the first inductor 551 when a gamma value is a fourth value (e.g., 3*10^-13) greater than the third value. A fifth curve 1025 is an impedance curve of the second capacitor component 722 and the first inductor 551 when a gamma value is a fifth value (e.g., 4* 10^-13) greater than the fourth value. A sixth curve 1026 is an impedance curve of the second capacitor component 722 and the first inductor 551 when a gamma value is a sixth value (e.g., 5*10^-13) greater than the fifth value.

A second range 1042 may be referred to as a range of impedance having a difference within about 1 dB with reference to a second point 1052 of the second chart 1002.

The larger the portion of the curve included within the second range 1042, the wider the operating frequency band of the first PAM 421 is. When the RF signals have a high power, the smaller the gamma value, the larger the portion of the curve included within the second range 1042 becomes.

As a result, as the gamma value decreases, the curve may have a relatively larger portion included within the second range 1042, and when the RF signals have a high power, as the gamma value decreases, the operating frequency band of the first PAM 421 may be widened.

However, when the RF signals have a high power, the first curve 1021 to the sixth curve 1026 may already be sufficiently included within the second range 1042. In this case, the gamma value may be considered preferentially when the RF signals have a low power rather than a high power, and the second capacitor component 722 and the first inductor 551 may be designed or configured to have a relatively low gamma value.

FIG. 10C illustrates an operating frequency range according to a change in a gamma value when RF signals have a peak power according to an embodiment.

Referring to FIG. 10C, a third Smith chart 1003 including curves having different gamma values when RF signals output from the first PAM 421 have a peak power is illustrated.

A first curve 1031 is an impedance curve of the second capacitor component 722 and the first inductor 551 when a gamma value is a first value, a second curve 1032 is an impedance curve of the second capacitor component 722 and the first inductor 551 when a gamma value is a second value greater than the first value, and a third curve 1033 is an impedance curve of the second capacitor component 722 and the first inductor 551 when a gamma value is a third value greater than the second value. A fourth curve 1034 is an impedance curve of the second capacitor component 722 and the first inductor 551 when a gamma value is a fourth value greater than the third value. A fifth curve 1035 is an impedance curve of the second capacitor component 722 and the first inductor 551 when a gamma value is a fifth value greater than the fourth value. A sixth curve 1036 is an impedance curve of the second capacitor component 722 and the first inductor 551 when a gamma value is a sixth value greater than the fifth value.

A third range 1043 may be referred to as a range of impedance having a difference within about 1 dB with reference to a third point 1053 of the third chart 1003.

The larger the portion of the curve included within the third range 1043, the wider the operating frequency band of the first PAM 421 is. When the RF signals have a peak power, the smaller the gamma value, the larger the portion of the curve included within the third range 1043 becomes.

As a result, as the gamma value decreases, the curve may have a relatively larger portion included within the third range 1043, and when the RF signals have a high power, as the gamma value decreases, the operating frequency band of the first PAM 421 may be widened.

However, when the RF signals have a peak power, the first curve 1031 to the sixth curve 1036 may already be sufficiently included within the third range 1043. In this case, the gamma value may be considered preferentially when the RF signals have a low power rather than a peak power, and the second capacitor component 722 and the first inductor 551 may be designed or configured to have a low gamma value.

Table 1 below illustrates operating frequency bands at a low power, a high power, and a peak power when a gamma value has the first value to the sixth value as described in FIGS. 10A to 10C. In Table 1, the total operating frequency band and a fractional operating frequency band when the gamma value has the first value to the sixth value are shown. For example, a fractional frequency band (FBW) may be determined based on Equation (5) below.

$$(\text{maximum frequency} - \text{minimum frequency}) / \sqrt{maximum\ frequency * minimum\ frequency} * 100 \quad \ldots(5)$$

The second capacitor component 722 and the first inductor 551 included in the first PAM 421 may be configured to have a low gamma value (e.g., 2* 10^-13 or 3* 10^-13).

Table 1

| Gamma value (γ) | Carrier LP 1-dB Bandwidth [GHz] | Carrier HP 1-dB Bandwidth [GHz] | Peaking HP 1-dB Bandwidth [GHz] | Total 1-dB Bandwidth [GHz] | Fractional Bandwidth [%] |
|---|---|---|---|---|---|
| 0 | 3.10 - 4.15 | 3.00 - 4.20 | 2.45 - 4.80 | 3.10 - 4.15 | 29.3 |
| 1*10^-13 | 3.00 - 4.25 | 2.55 - 4.65 | 2.35 - 4.90 | 3.00 - 4.25 | 35.0 |
| 2*10^-13 | 2.85 - 4.40 | - | 2.40 - 4.85 | 2.85 - 4.40 | 43.8 |
| 3*10^-13 | 2.65 - 4.55 | 2.85 - 4.35 | 2.60 - 4.65 | 2.85 - 4.35 | 42.6 |
| 4*10^-13 | 2.60 - 4.65 | 3.15 - 4.05 | 2.85 - 4.40 | 3.15 - 4.05 | 25.2 |
| 5*10^-13 | 2.85 - 4.35 | 3.25 -3.95 | 3.00 - 4.25 | 3.25 - 3.95 | 19.5 |

FIG. 11 illustrates a method for separating a first capacitor component according to an embodiment.

Referring to FIG. 11, the QWTL 710 having a characteristic impedance ($Z_{QWTL}$) may be determined based on a configured resonant frequency $w_0$. For example, the QWTL 710 having the characteristic impedance may be converted into the first capacitor 541 and the second capacitor 542 having an equivalently specified capacitance value (e.g., $C_P$), and an inductor 1111 having a specified inductance value (e.g., $L_S$). For example, the first capacitor 541, the second capacitor 542, and the inductor 1111 may be a lumped QWTL having a low pass Pi type.

The specified capacitance value (e.g., $C_P$) may be obtained through Equation (6) below, and the specified inductance value (e.g., $L_S$) may be obtained through Equation (7) below. Referring to Equation (6) and Equation (7), the specified capacitance value (e.g., $C_P$) may be determined based on a resonant frequency $w_0$.

$$C_P = \frac{1 - \cos 90°}{w_0 Z_{QWTL} \sin 90°} \quad \ldots(6)$$

$$L_S = \frac{Z_{QWTL}}{w_0} \sin 90° \quad \ldots(7)$$

The first transistor 531 may be equivalently converted into the first current source 731 and the first capacitor 541. The second transistor 532 may be equivalently converted into the second current source 732 and the second capacitor 542.

The first capacitor 541 may be divided into the first capacitor component 721 for configuring a QWTL and the second capacitor component 722 for LC resonance of the first PAM 421. For example, a capacitance value (e.g., $C_{QWTL}$) of the first capacitor component 721 may be determined to be greater than the specified capacitance value (e.g., $C_P$) and less than a capacitance value (e.g., $C_{out.p}$) of the first capacitor 541.

For example, the capacitance value of the first capacitor component 721 may be determined based on a specified frequency band (or resonant frequency). In an example, the specified capacitance value (e.g., $C_P$) is determined based on a resonant frequency as in Equation (6) above, and the capacitance value of the first capacitor component 721 is determined based on the specified capacitance value. Accordingly, the capacitance value of the first capacitor component 721 may be determined based on the specified frequency band (or resonant frequency).

For example, a capacitance value of the second capacitor component 722 may be determined based on an inductance value of the first inductor 551 and a capacitance value of the third capacitor 543. For example, the capacitance value of the second capacitor component 722 may be a value (e.g., $C_R$) obtained by subtracting the capacitance value (e.g., $C_{QWTL}$) of the first capacitor component 721 from the capacitance value (e.g., $C_{out.p}$) of the first capacitor 541.

FIG. 12 illustrates a method for determining a reference inductor for LC resonance of a first PAM according to an embodiment.

Referring to FIG. 12, the first PAM 421 may include a first additional inductor 1211 for offsetting a first capacitor component 721. The first PAM 421 may include a second additional inductor 1212 for offsetting the second capacitor 542.

The first additional inductor 1211 may attenuate a capacitance value (e.g., $C_{QWTL}$) of the first capacitor component 721 such that the capacitance value of the first capacitor component 721 corresponds to a specified capacitance value (e.g., $C_P$). For example, the sum of impedances of the first additional inductor 1211 and the first capacitor component 721 may be the specified capacitance value (e.g., $C_P$).

The second additional inductor 1212 may attenuate the capacitance value of the first capacitor component 721 such that a capacitance value (e.g., $C_{out.c}$) of the second capacitor 542 corresponds to the specified capacitance value (e.g., $C_P$). For example, the sum of impedances of the second additional inductor 1212 and the second capacitor 542 may be the specified capacitance value (e.g., $C_P$).

An inductance value (e.g., $L_A$) of the first additional inductor 1211 may be obtained through Equation (8) below, and an inductance value (e.g., $L_B$) of the second additional inductor 1212 may be obtained through Equation (9) below.

$$L_A = \frac{1}{wo^2 (C_{QWTL} - C_P)} \quad \ldots(8)$$

$$L_B = \frac{1}{wo^2(C_{out,c} - C_P)} \quad \dots(9)$$

In Equations (8) and (9), $w_0$ may be a resonant frequency of the first PAM 421. $C_{out.c}$ may be a capacitance value of the second capacitor 542. $C_{QWTL}$ may be a capacitance value of the first capacitor component 721. $C_P$ may be a specified capacitance value obtained through Equation (5).

The first PAM 421 may include a reference inductor 1220 for offsetting a capacitance value (e.g., $C_R$) of the second capacitor component 722.

The reference inductor 1220 may be configured to offset the capacitance value (e.g., $C_R$) of the second capacitor component 722 to determine a resonant frequency band of RF signals output by the first PAM 421. For example, a resonant frequency (or a resonant frequency band) (e.g., $w_0$) of the RF signals output by the first PAM 421 may be determined based on an inductance value (e.g., $L_R$) of the reference inductor 1220 and the capacitance value (e.g., $C_R$) of the second capacitor component 722. For example, the resonant frequency of the RF signals output by the first PAM 421 may be determined based on the product of the inductance value (e.g., $L_R$) of the reference inductor 1220 and the capacitance value (e.g., $C_R$) of the second capacitor component 722.

Equation (10) below is given for obtaining a resonant frequency $w_0$ based on the inductance value (e.g., $L_R$) of the reference inductor 1220 and the capacitance value (e.g., $C_R$) of the second capacitor component 722.

$$L_R = \frac{{w_0}^2}{C_R} \quad \dots(10)$$

FIG. 13 illustrates T-type conversion and addition of a third capacitor for DC current prevention according to an embodiment.

Referring to FIG. 13, the first PAM '421 may include the third capacitor 543 for blocking a DC (e.g., DC power). For example, the third capacitor 543 may be connected in series to the first node 591. For example, the third capacitor 543 may be disposed between the first node 591 and the third ground 563. For example, the third capacitor 543 may electrically connect the first node 591 and the third ground 563. For example, the third capacitor 543 may be electrically connected to the reference inductor 1220.

The third capacitor 543 may be disposed between an inductor (e.g., the reference inductor 1220 or the first inductor 551) and the third ground 563 to reduce or minimize leakage of a DC (e.g., DC power) to ground. For example, the power supply source 571 may supply a DC (e.g., DC power) to the first transistor 531 and the second transistor 532 through the first connection line 581 and the second connection line 582. In this case, since the inductor (e.g., the reference inductor 1220 or the first inductor 551) is connected to the first node 591, the DC (e.g., DC power) may leak to the third ground 563 through the inductor. When the DC (e.g., DC power) leaks, power supply to the first transistor 531 and the second transistor 532 may be insufficient. In addition, a part of the DC leaked to the third ground 563 may be reflected and thus cause damage to the inductor or the first transistor 531.

However, when the third capacitor 543 is disposed between the inductor (e.g., the reference inductor 1220 or the first inductor 551) and the third ground 563, DC leakage to the ground may be reduced or minimized.

When the third capacitor 543 is connected in series to the reference inductor 1220, the overall capacitance value of an LC resonant part 1320 may be increased. For example, the LC resonant part 1320 may include the second capacitor component 722, the reference inductor 1220, and the third capacitor 543. As the third capacitor 543 is connected in parallel to the second capacitor component 722, the overall capacitance value of the LC resonant part 1320 may be increased.

Even when the third capacitor 543 is connected in series to the reference inductor 1220, the impedance sum of the LC resonant part 1320 may be required to be 0 at a resonant frequency $w_0$. Accordingly, the reference inductor 1220 may be replaced with the first inductor 551 having a first inductance value (e.g., $L_1$).

As a result, when the third capacitor 543 is connected in series to the first inductor 551, a capacitance value (e.g., $C_3$) of the third capacitor 543 may be determined based on an inductance value (e.g., $L_1$) of the first inductor 551 and a capacitance value (e.g., $C_R$) of the second capacitor component 722. For example, the capacitance value (e.g., $C_3$) of the third capacitor 543 may be determined such that the sum of the capacitance value (e.g., $C_3$) of the third capacitor, the inductance value (e.g., $L_1$) of the first inductor 551, and the capacitance value (e.g., $C_R$) of the second capacitor component 722 becomes 0.

Equation (11) below is a relationship equation between the inductance value (e.g., $L_1$) of the first inductor 551 and the capacitance value (e.g., $C_3$) of the third capacitor 543.

$$jwL_R = jwL_1 + \frac{1}{jwC_1}$$

…(11)

The sum of the first inductor 551, the first capacitor 541, and the third capacitor 543 may correspond to 0, an inductance value, or a capacitance value, based on frequency bands of a first signal and a second signal input to the first PAM 421. For example, when the frequency band of the first signal and the second signal input to the first PAM 421 is less than a designed resonant frequency band, the sum of impedances of the first inductor 551, the second capacitor component 722 of the first capacitor 541, and the third capacitor 543 may correspond to the inductance value. When the frequency bands of the first signal and the second signal input to the first PAM 421 are greater than the resonant frequency band, the sum of impedances of the first inductor 551, the second capacitor component 722 of the first capacitor 541, and the third capacitor 543 may correspond to the capacitance value.

Combinations of the inductance value (e.g., $L_1$) of the first inductor 551 and the capacitance value (e.g., $C_3$) of the third capacitor 543, which satisfy Equation 11) above may vary. In this case, the first PAM 421 may include a combination of the first inductor 551 and the third capacitor 543, which allows the first PAM 421 to have a relatively wide operating frequency band, among the combinations satisfying Equation (11).

Each of the first additional inductor 1211 and the second additional inductor 1212 included in the first PAM 421 is directly connected to ground, and thus may affect LC resonance of the first PAM 421. In addition, to prevent a DC power from flowing to the ground, an additional capacitor may be required to be added between the first additional inductor 1211 and the ground, and an additional capacitor may be required to be added between the second additional inductor 1212 and the ground. In this case, the size of the first PAM 421 may be increased as a lumped element is added within the first PAM 421.

In the first PAM 421, to prevent the size of the first PAM from increasing due to the additional capacitor, the first additional inductor 1211, the second additional inductor 1212, and the inductor 1111 may be converted into a T-type arrangement. For example, based on the sum of inductances of the first additional inductor 1211, the second additional inductor 1212, and the inductor 1111, the second inductor 552 and the third inductor 553 may be included in the second connection line 582, and the fourth inductor 554 may be connected in parallel to the second connection line 582.

As a result, as the second inductor 552 and the third inductor 553 are included in the second connection line 582 and the fourth inductor 554 is connected to the second connection line 582, the first PAM 421 may be reduced or minimized.

The first PAM 421 after the T-type conversion of FIG. 13 may have substantially the same structure as the first PAM 421 described in FIG. 5.

FIG. 14 illustrates graphs for when there is no first capacitor and a case where a first capacitor is connected between a first node and a first ground according to an embodiment.

Referring to FIG. 14, impedance curves when RF signals output from the first PAM 421 have a low power, a high power, and a peak power when the first inductor 551 and the third capacitor 543 are not connected to the first node 591 are illustrated. For example, a first curve 1401 is an impedance curve when the RF signals have a peak power when the first inductor 551 and the third capacitor 543 are not connected to the first node 591. For example, a second curve 1402 is an impedance curve when the RF signals have a high power when the first inductor 551 and the third capacitor 543 are not connected to the first node 591. For example, a third curve 1403 is an impedance curve when the RF signals have a low power when the first inductor 551 and the third capacitor 543 are not connected to the first node 591.

Impedance curves when RF signals output from the first PAM 421 have a low power, a high power, and a peak power when the first inductor 551 and the third capacitor 543 are connected to the first node 591 are illustrated. For example, a fourth curve 1404 is an impedance curve when the RF signals have a peak power when the first inductor 551 and the third capacitor 543 are connected to the first node 591. For example, a fifth curve 1405 is an impedance curve when the RF signals have a high power when the first inductor 551 and the third capacitor 543 are connected to the first node 591. For example, a sixth curve 1406 is an impedance curve when the RF signals have a low power when the first inductor 551 and the third capacitor 543 are connected to the first node 591.

When comparing the first curve 1401 and the fourth curve 1404, the fourth curve 1404 may have a larger portion included within a first range 1411 than the first curve 1401. Therefore, when RF signals output from the first PAM 421 have a peak power, as the first inductor 551 and the third capacitor 543 are connected to the first node 591, the first PAM 421 may secure a wide operating frequency band of signals outputted by the first PAM 421.

When comparing the second curve 1402 and the fifth curve 1405, the fifth curve 1405 may have a larger portion included within a second range 1412 than the second curve 1402. Therefore, when RF signals output from the first PAM 421 have a high power, as the first inductor 551 and the third capacitor 543 are connected to the first node 591, the first PAM 421 may secure a wide operating frequency band.

When comparing the third curve 1403 and the sixth curve 1406, the sixth curve 1406 may have a larger portion included within a third range 1413 than the third curve 1403. Therefore, when RF signals output from the first PAM 421 have a low power, as the first inductor 551 and the third capacitor 543 are connected to the first node 591, the first PAM 421 may secure a wide operating frequency band.

As described above, an electronic device in a wireless communication system may include a first transistor including a first capacitor and configured to receive a first signal and, when the first signal is greater than or equal to a specified voltage, amplify and output the first signal as a first RF signal, a second transistor including a second capacitor and configured to receive a second signal and amplify and output the second signal as a second RF signal, a first connection line which is connected to the first transistor and through which the first RF signal is transmitted, a second connection line which is connected to the second transistor and through which the second RF signal is transmitted, a first inductor connected to a first node, and a third capacitor configured to connect the first inductor and ground, wherein the first connection line and the second connection line are connected at the first node, and a impedance sum of the first inductor, the first capacitor, and the third capacitor is configured such that the first RF signal and the second RF signal resonate in a specified frequency band.

The second connection line may include a second inductor and a third inductor configured to connect the second transistor and the first node, and a fourth inductor connected to a second node between the second inductor and the third inductor, wherein a DC for driving the first transistor and the second transistor is supplied through the fourth inductor.

The third capacitor may block the DC power supplied to the first transistor and the second transistor from flowing to the ground.

The second inductor may be connected to the second transistor to attenuate a capacitance value of the second capacitor, and the third inductor may be connected to the first node to attenuate a capacitance value of the first capacitor.

Each of the second inductor and the third inductor may be connected to the ground through the first inductor and the third capacitor.

The first capacitor may include a first capacitor component and a second capacitor component, wherein a capacitance value of the first capacitor component is determined based on the specified frequency band, and a capacitance value of the second capacitor component is determined based on an inductance value of the first inductor and a capacitance value of the third capacitor.

When frequency band of the first signal and the second signal is less than the specified frequency band, a impedance sum of the first inductor, the second capacitor component, and the third capacitor corresponds to an inductance, and when the frequency bands of the first signal and the second signal are greater than the specified frequency band, the sum of the impedances of the first inductor, the second capacitor component, and the third capacitor corresponds to a capacitance.

The inductance value of the first inductor may be a sum of the capacitance value of the second capacitor component and the capacitance value of the third capacitor.

The electronic device may further include at least one antenna, and a third connection line configured to connect the first node and the at least one antenna, wherein the first RF signal is transmitted to the at least one antenna through the first connection line and the third connection line, and the second RF signal is transmitted to the at least one antenna through the second connection line and the third connection line.

The third connection line connected to the first node may further include a circuit configured to match the impedances, and the circuit may include at least one lumped element.

The electronic device may further include a mixer configured to generate a signal of the specified frequency band, and a distributor connected to the first transistor and the second transistor, wherein the distributor is configured to receive a signal of the specified frequency band from the mixer, and based on the signal of the specified frequency band, transmit the first RF signal to the first transistor and transmit the second RF signal to the second transistor.

The electronic device may further include a phase compensator configured to connect the first transistor and the distributor, wherein the phase compensator is configured to control a phase of the first signal such that the phase of the first signal and a phase of the second signal have as large a difference as a specified value therebetween.

The electronic device may further include a first chip including the first transistor, a second chip including the second transistor, and a PCB on which the first connection line and the second connection line are disposed, wherein the first connection line and the second connection line are at least one of a microstrip line, a bond wire, or a conductive via of the PCB.

The first capacitor may have a capacitance value different from a capacitance value of the second capacitor.

Each of the first RF signal and the second RF signal may have a first polarization.

A As described above, a PA module may include a first transistor including a first capacitor and configured to receive a first signal and, when the first signal is greater than or equal to a specified voltage, amplify and output the first signal as a first RF signal, a second transistor including a second capacitor and configured to receive a second signal and amplify and output the second signal as a second RF signal, a first connection line which is connected to the first transistor and through which the first RF signal is transmitted, a second connection line which is connected to the second transistor and through which the second RF signal is transmitted, a first inductor connected to a first node, and a third capacitor configured to connect the first inductor and ground, wherein the first connection line and the second connection line are connected at the first node, and a impedance sum of the first inductor, the first capacitor, and the third capacitor is configured such that the first RF signal and the second RF signal resonate in a specified frequency band.

The second connection line may include a second inductor and a third inductor configured to connect the second transistor and the first node, and a fourth inductor connected to a second node between the second inductor and the third inductor, wherein a DC for driving the first transistor and the second transistor is supplied through the fourth inductor.

The third capacitor may block the DC power supplied to the first transistor and the second transistor from flowing to the ground.

The second inductor may be connected to the first transistor to attenuate a capacitance value of the second capacitor, and the third inductor may be connected to the first node to attenuate a capacitance value of the third capacitor.

Each of the second inductor and the third inductor may be connected to the ground through the first inductor and the third capacitor.

While the disclosure has been described with reference to various embodiments, various changes may be made without departing from the spirit and the scope of the present disclosure, which is defined, not by the detailed description and embodiments, but by the appended claims and their equivalents.

Although exemplary embodiments of the disclosure have been described and shown in the specification and the drawings by using particular terms, they have been used in a general sense merely to easily explain the technical contents of the disclosure and help understanding of the disclosure, and are not intended to limit the scope of the disclosure. It will be apparent to those skilled in the art that, in addition to the embodiments set forth herein, other variants based on the technical idea of the disclosure may be implemented.

## Claims

**1.** An electronic device in a wireless communication system, the electronic device comprising:

a first transistor configured to receive a first signal, wherein the first transistor comprises a first capacitor, and wherein the first transistor is configured to amplify and output the first signal as a first radio frequency (RF) signal in case that the first signal is greater than or equal to a specified voltage;
a second transistor configured to receive a second signal, wherein the second transistor comprises a second capacitor, and wherein the second transistor is configured to amplify and output the second signal as a second RF signal;
a first connection line which is connected to the first transistor and in which the first RF signal is transmitted;
a second connection line which is connected to the second transistor and in which the second RF signal is transmitted, wherein the first connection line and the second connection line are connected at a first node;
a first inductor connected to the first node; and
a third capacitor configured to connect the first inductor and ground,
wherein a sum of impedances of the first inductor, the first capacitor, and the third capacitor is configured such that the first RF signal and the second RF signal resonate in a specified frequency band.

**2.** The electronic device of claim 1, wherein the second connection line comprises:

a second inductor and a third inductor configured to connect the second transistor and the first node; and
a fourth inductor connected to a second node between the second inductor and the third inductor, and
wherein a direct current (DC) for driving the first transistor and the second transistor is supplied through the fourth inductor.

**3.** The electronic device of claim 2,
wherein the third capacitor is configured to block the DC supplied to the first transistor and the second transistor from flowing to the ground.

**4.** The electronic device of claim 2,

wherein the second inductor is connected to the second transistor to attenuate a capacitance value of the second capacitor, and
wherein the third inductor is connected to the first node to attenuate a capacitance value of the first capacitor.

**5.** The electronic device of claim 2,
wherein each of the second inductor and the third inductor is connected to the ground through the first inductor and the third capacitor.

**6.** The electronic device of claim 1,

wherein the first capacitor comprises a first capacitor component and a second capacitor component,
wherein a capacitance value of the first capacitor component is determined based on the specified frequency band, and
wherein a capacitance value of the second capacitor component is determined based on an inductance value of the first inductor and a capacitance value of the third capacitor.

**7.** The electronic device of claim 6,

wherein in case that a frequency band of the first signal and the second signal is less than the specified frequency band, a sum of impedances of the first inductor, the second capacitor component, and the third capacitor corresponds to an inductance, and
wherein in case that the frequency band of the first signal and the second signal is greater than the specified frequency band, the sum of the impedances of the first inductor, the second capacitor component, and the third capacitor corresponds to a capacitance.

**8.** The electronic device of claim 6,
wherein the inductance value of the first inductor is a sum of the capacitance value of the second capacitor component and the capacitance value of the third capacitor.

**9.** The electronic device of claim 1, further comprising:

at least one antenna; and
a third connection line configured to connect the first node and the at least one antenna,
wherein the first RF signal is transmitted to the at least one antenna through the first connection line and the third connection line, and
wherein the second RF signal is transmitted to the at least one antenna through the second connection line and the third connection line.

**10.** The electronic device of claim 9,

wherein the third connection line connected to the first node further comprises a circuit configured to match the impedances, and
wherein the circuit comprises at least one lumped element.

**11.** The electronic device of claim 1, further comprising:

a mixer configured to generate a signal of the specified frequency band; and
a distributor connected to the first transistor and the second transistor,
wherein the distributor is configured to:

receive a signal of the specified frequency band from the mixer; and
based on the signal of the specified frequency band, transmit the first RF signal to the first transistor and transmit the second RF signal to the second transistor.

**12.** The electronic device of claim 1, further comprising a phase compensator configured to connect the first transistor and the distributor,
wherein the phase compensator is configured to control a phase of the first signal such that the phase of the first signal and a phase of the second signal have a difference corresponding to a specified value.

**13.** The electronic device of claim 1, further comprising:

a first chip comprising the first transistor;
a second chip comprising the second transistor; and
a printed circuit board (PCB) on which the first connection line and the second connection line are disposed,

wherein the first connection line and the second connection line are at least one of a microstrip line, a bond wire, or a conductive via of the PCB.

**14.** The electronic device of claim 1,
wherein the first capacitor has a capacitance value different from a capacitance value of the second capacitor.

**15.** A power amplifier module (PAM) comprising:

a first transistor configured to receive a first signal, wherein the first transistor comprises a first capacitor, and wherein the first transistor is configured to amplify and output the first signal as a first radio frequency (RF) signal in case that the first signal is greater than or equal to a specified voltage;
a second transistor configured to receive a second signal, wherein the second transistor comprises a second capacitor, and wherein the second transistor is configured to amplify and output the second signal as a second RF signal;
a first connection line which is connected to the first transistor and in which the first RF signal is transmitted;
a second connection line which is connected to the second transistor and in which the second RF signal is transmitted, wherein the first connection line and the second connection line are connected at a first node;
a first inductor connected to the first node; and
a third capacitor configured to connect the first inductor and ground,
wherein a sum of impedances of the first inductor, the first capacitor, and the third capacitor is configured such that the first RF signal and the second RF signal resonate in a specified frequency band.

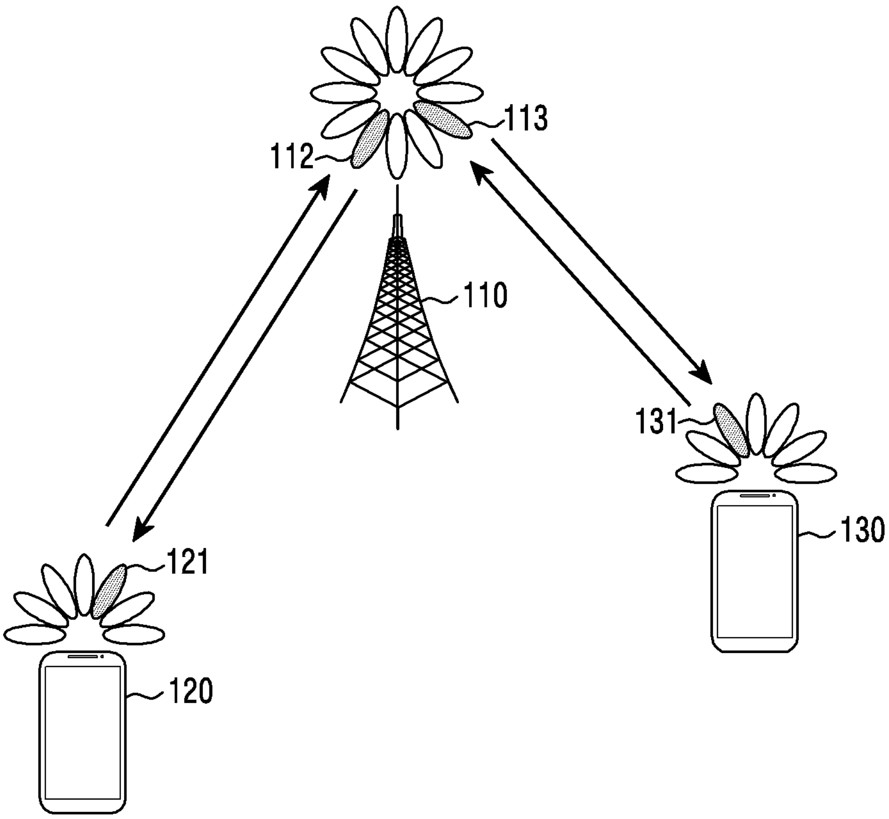


FIG.1

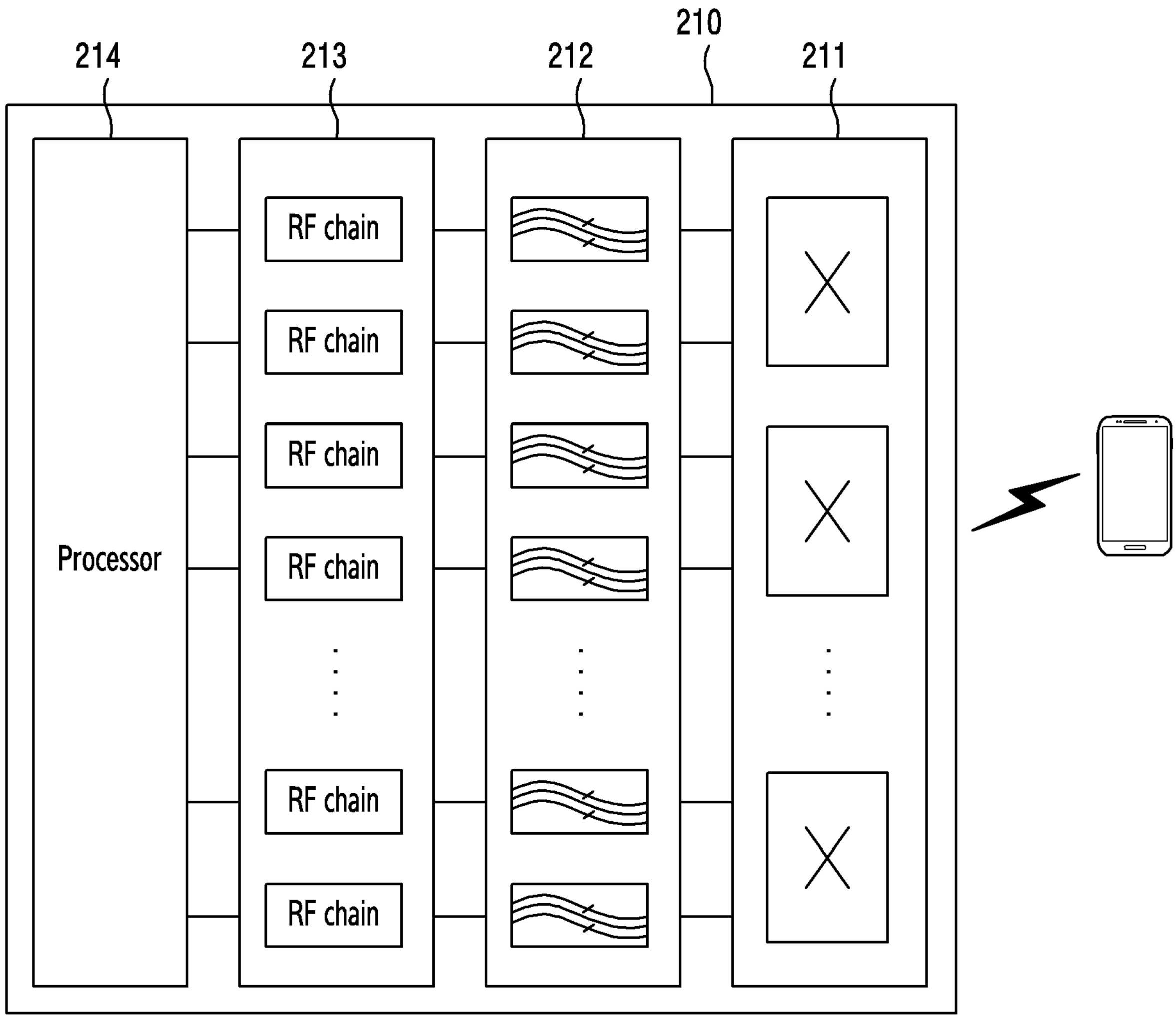
210
214
213
212
211
Processor
RF chain
RF chain
RF chain
RF chain
RF chain
RF chain

FIG.2

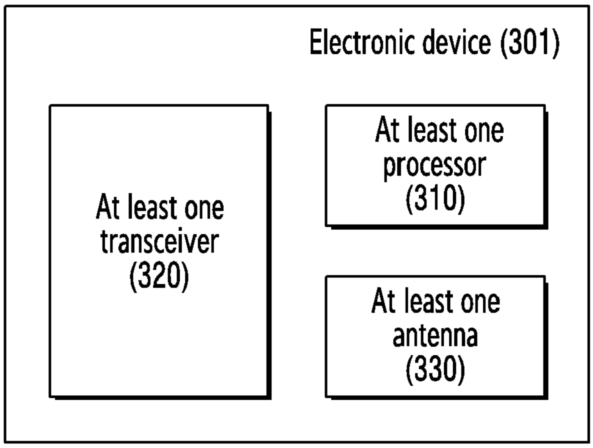
Electronic device (301)
At least one transceiver (320)
At least one processor (310)
At least one antenna (330)

FIG.3

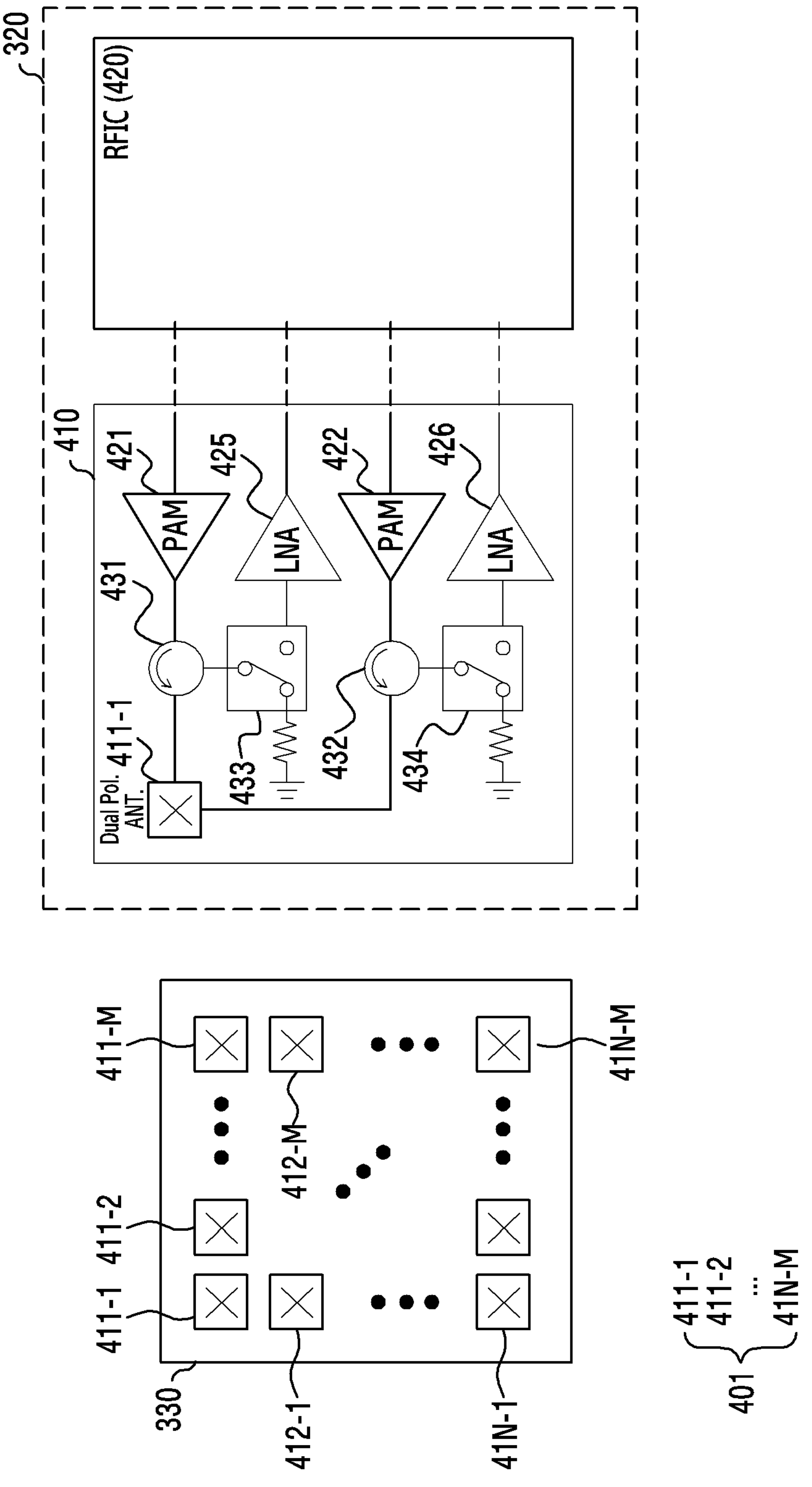
320
RFIC (420)
410
421
PAM
425
LNA
422
PAM
426
LNA
431
Dual Pol. ANT.
411-1
433
432
434
411-M
411-2
411-1
412-M
41N-M
330
412-1
41N-1
401
411-1
411-2
...
41N-M

FIG. 4

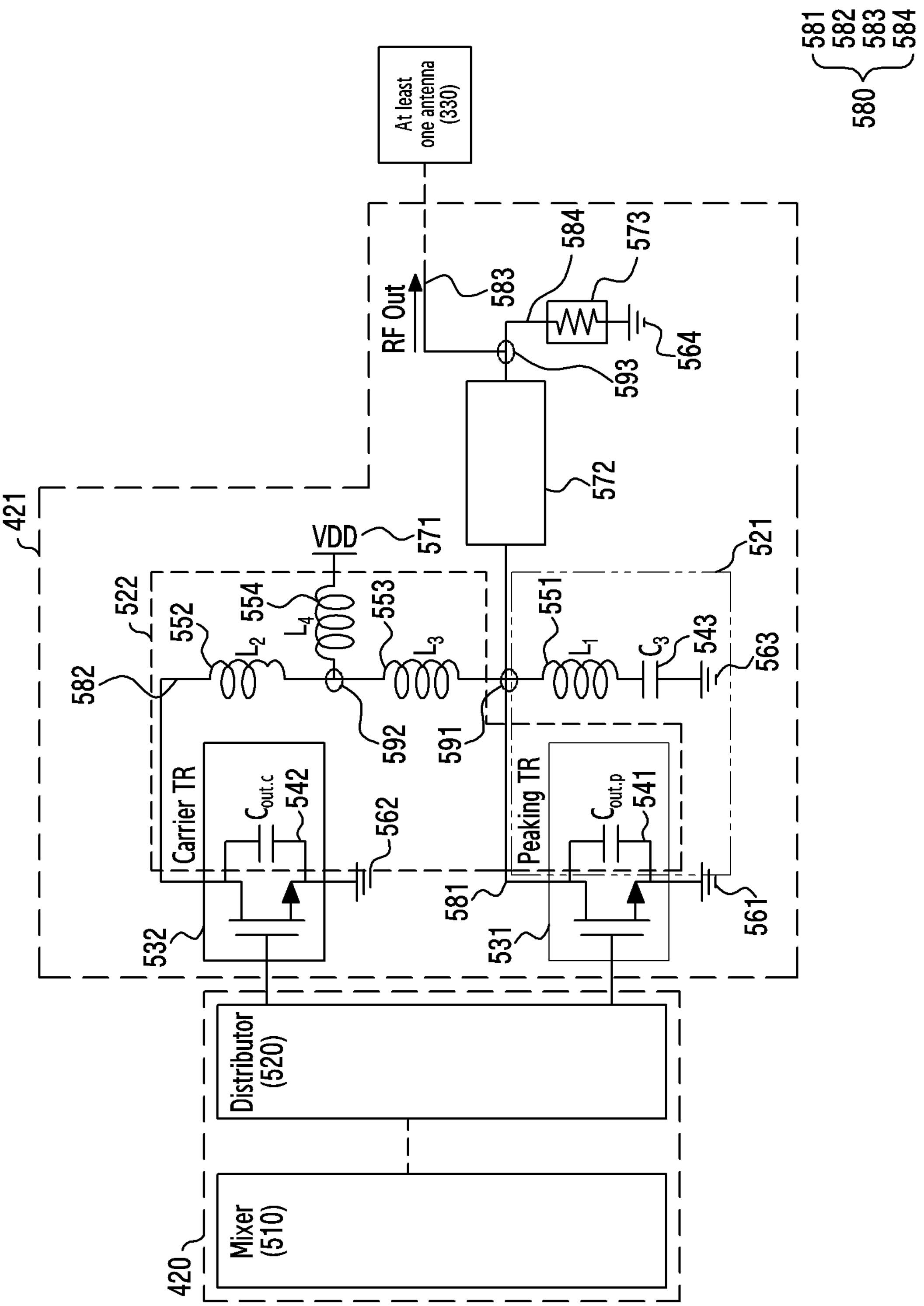
At least one antenna (330)
RF Out
VDD
Carrier TR
Peaking TR
Distributor (520)
Mixer (510)
$C_{out.c}$
$C_{out.p}$
$L_1$
$L_2$
$L_3$
$L_4$
$C_3$
580
581
582
583
584
421
420
522
521
552
554
553
551
543
563
571
572
573
564
593
592
591
542
541
562
561
532
531

FIG.5

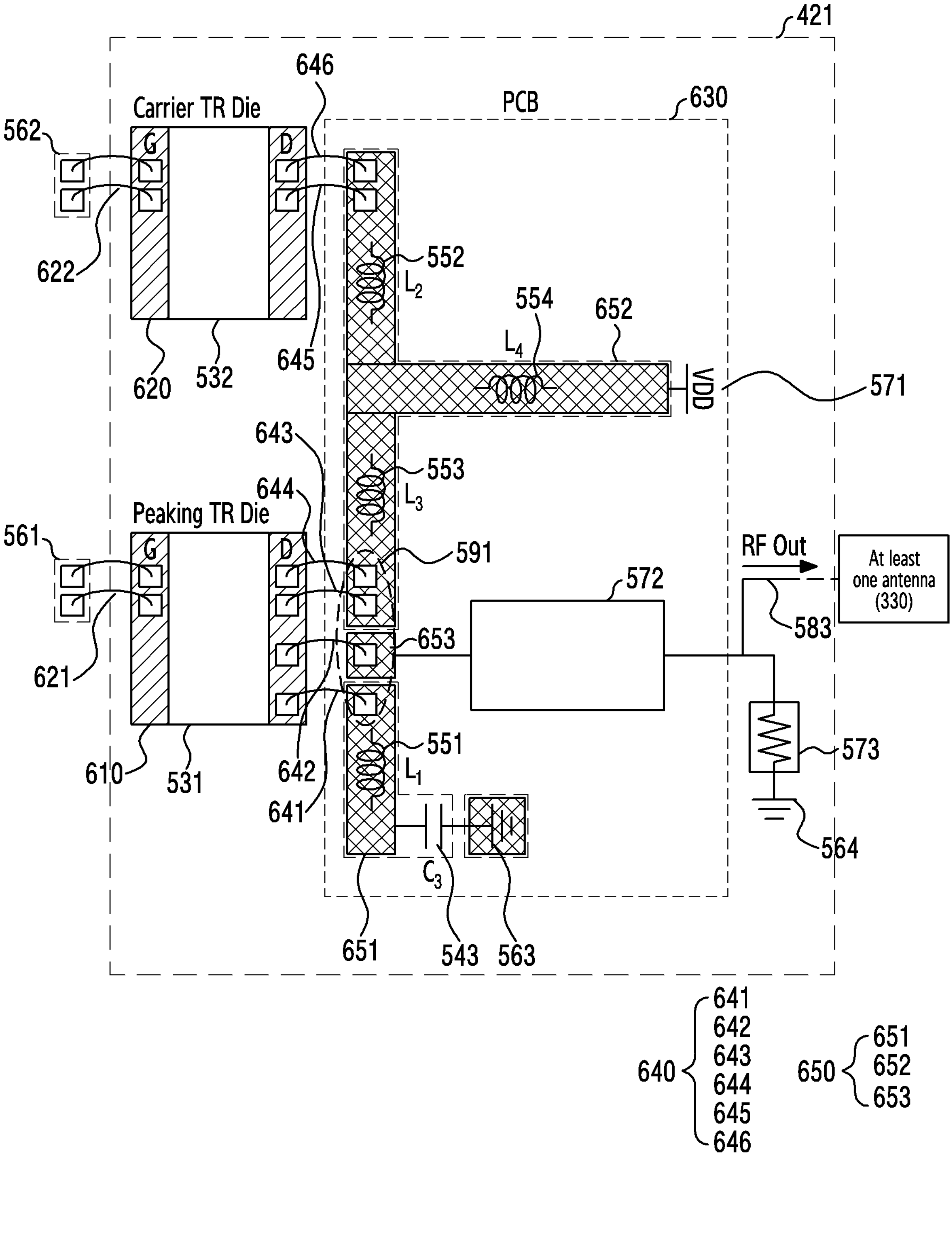
421
PCB
630
Carrier TR Die
G
D
562
646
622
552
$L_2$
554
652
$L_4$
620
532
645
VDD
571
643
553
$L_3$
644
Peaking TR Die
G
D
561
591
RF Out
At least one antenna (330)
572
583
621
653
573
551
$L_1$
610
531
642
641
$C_3$
564
651
543
563
640
641
642
643
644
645
646
650
651
652
653

FIG.6

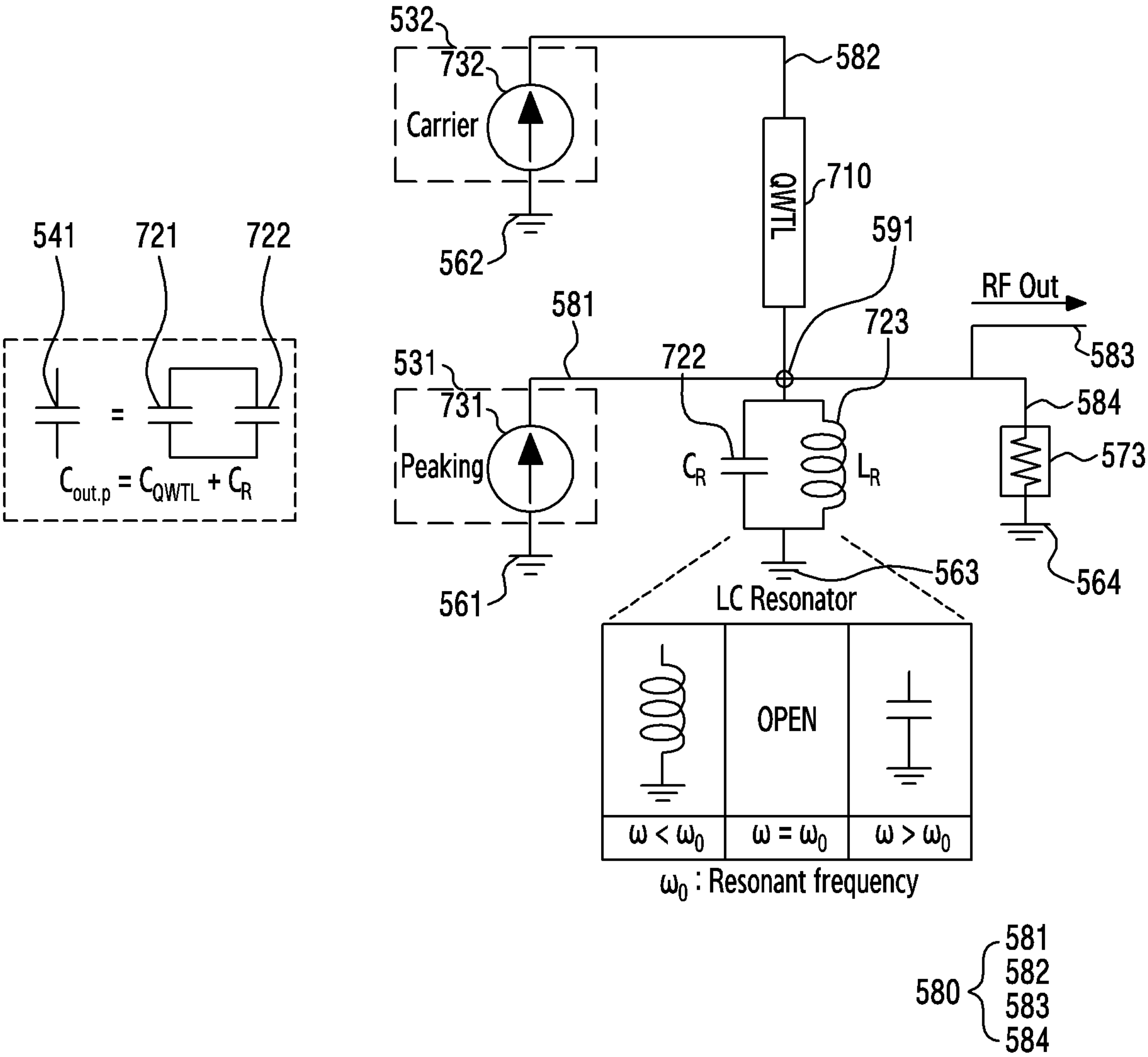
541
721
722
$C_{out.p} = C_{QWTL} + C_R$
532
732
Carrier
562
582
QWTL
710
591
581
531
731
Peaking
561
722
723
$C_R$
$L_R$
RF Out
583
584
573
564
563
LC Resonator
OPEN
$\omega < \omega_0$
$\omega = \omega_0$
$\omega > \omega_0$
$\omega_0$ : Resonant frequency
580
581
582
583
584

FIG.7

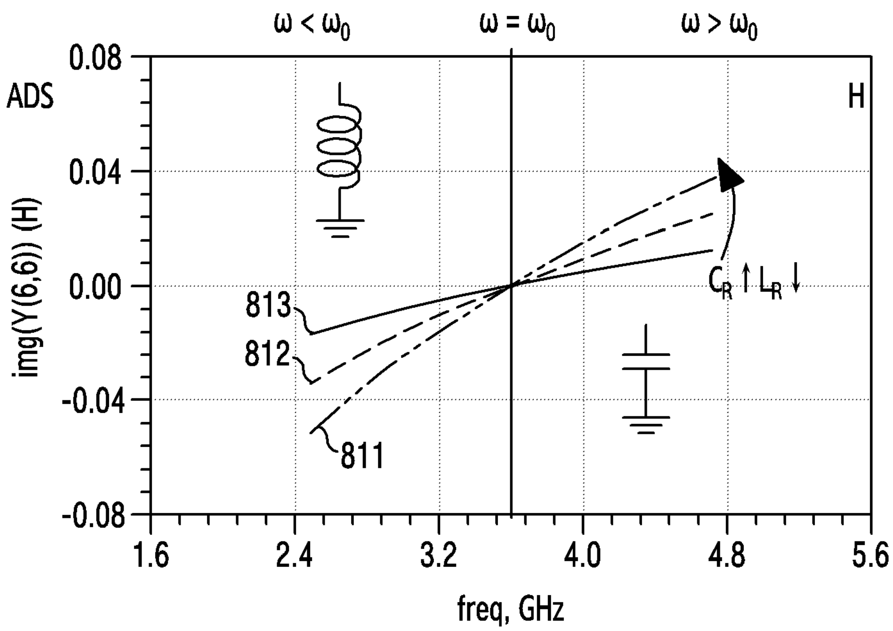
ω < ω0
ω = ω0
ω > ω0
0.08
0.04
0.00
-0.04
-0.08
ADS
H
img(Y(6,6)) (H)
813
812
811
CR ↑ LR ↓
1.6
2.4
3.2
4.0
4.8
5.6
freq, GHz

FIG.8

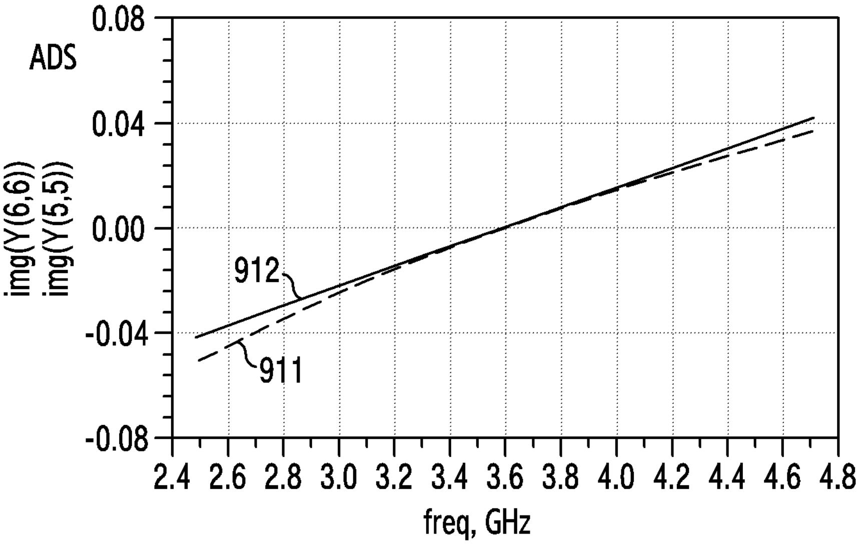
0.08
ADS
0.04
0.00
-0.04
-0.08
img(Y(6,6))
img(Y(5,5))
912
911
2.4 2.6 2.8 3.0 3.2 3.4 3.6 3.8 4.0 4.2 4.4 4.6 4.8
freq, GHz

FIG.9

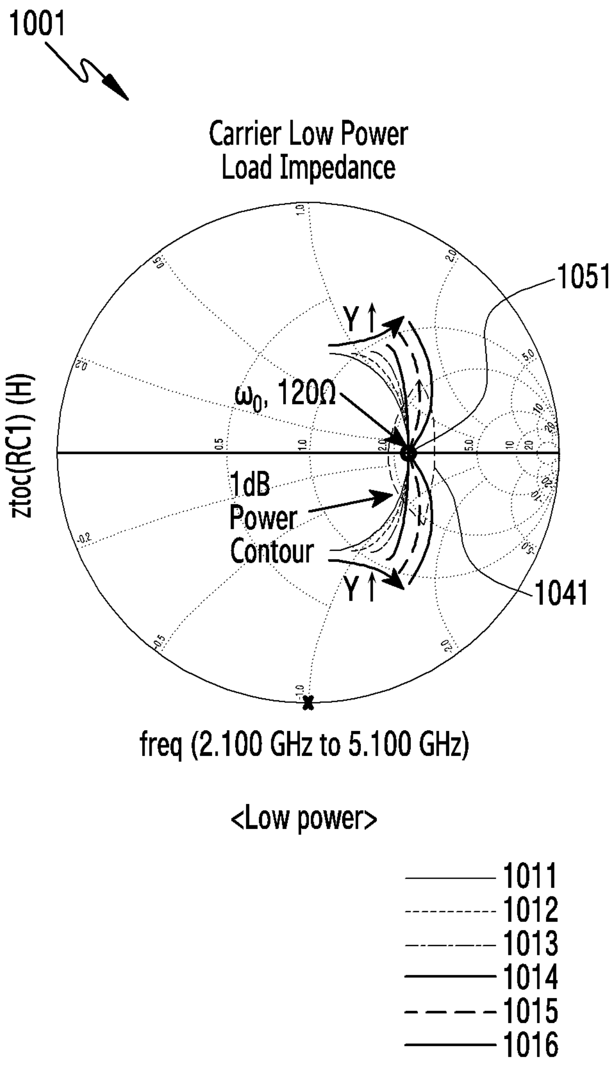
1001
Carrier Low Power
Load Impedance
1051
ω0, 120Ω
1dB
Power
Contour
Y ↑
Y ↑
1041
ztoc(RC1) (H)
freq (2.100 GHz to 5.100 GHz)
<Low power>
1011
1012
1013
1014
1015
1016

FIG.10A

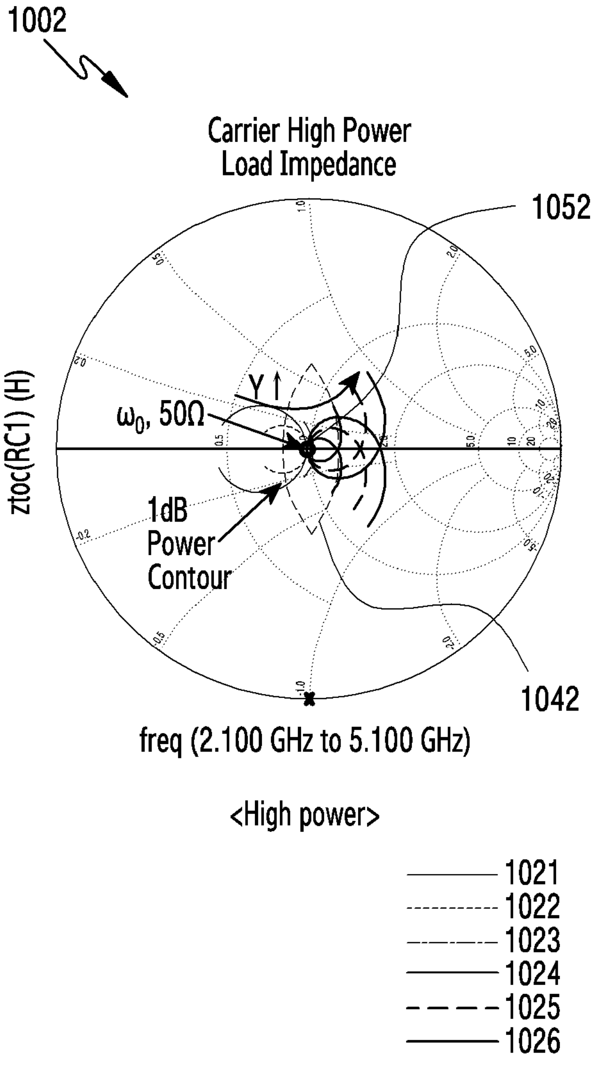
1002
Carrier High Power
Load Impedance
1052
ztoc(RC1) (H)
Y
ω0, 50Ω
1dB
Power
Contour
1042
freq (2.100 GHz to 5.100 GHz)
<High power>
1021
1022
1023
1024
1025
1026

FIG.10B

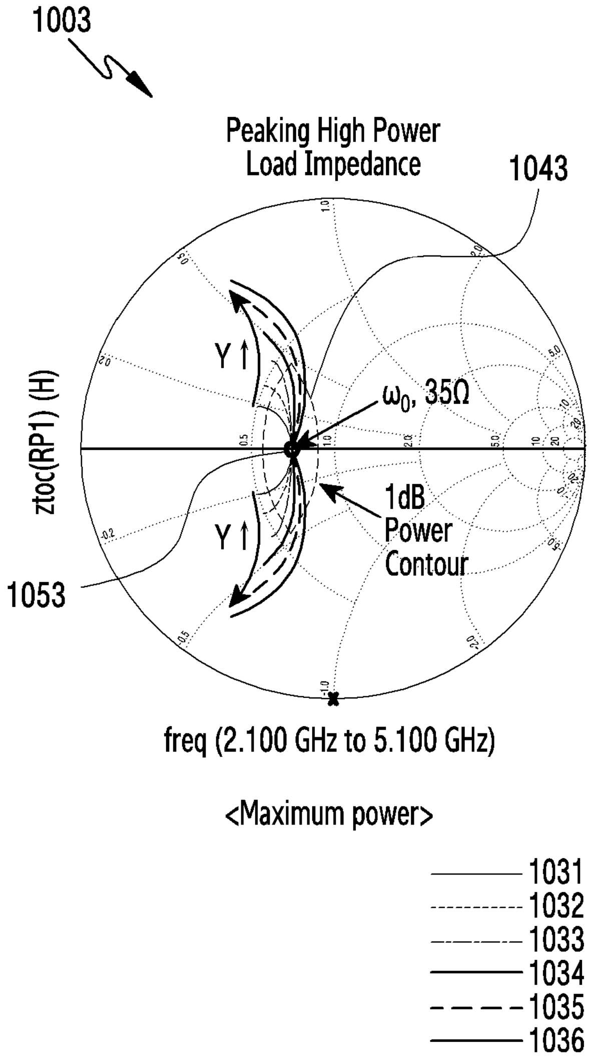
1003
Peaking High Power
Load Impedance
1043
ztoc(RP1) (H)
Y
ω0, 35Ω
1dB
Power
Contour
Y
1053
freq (2.100 GHz to 5.100 GHz)
<Maximum power>
1031
1032
1033
1034
1035
1036

FIG.10C

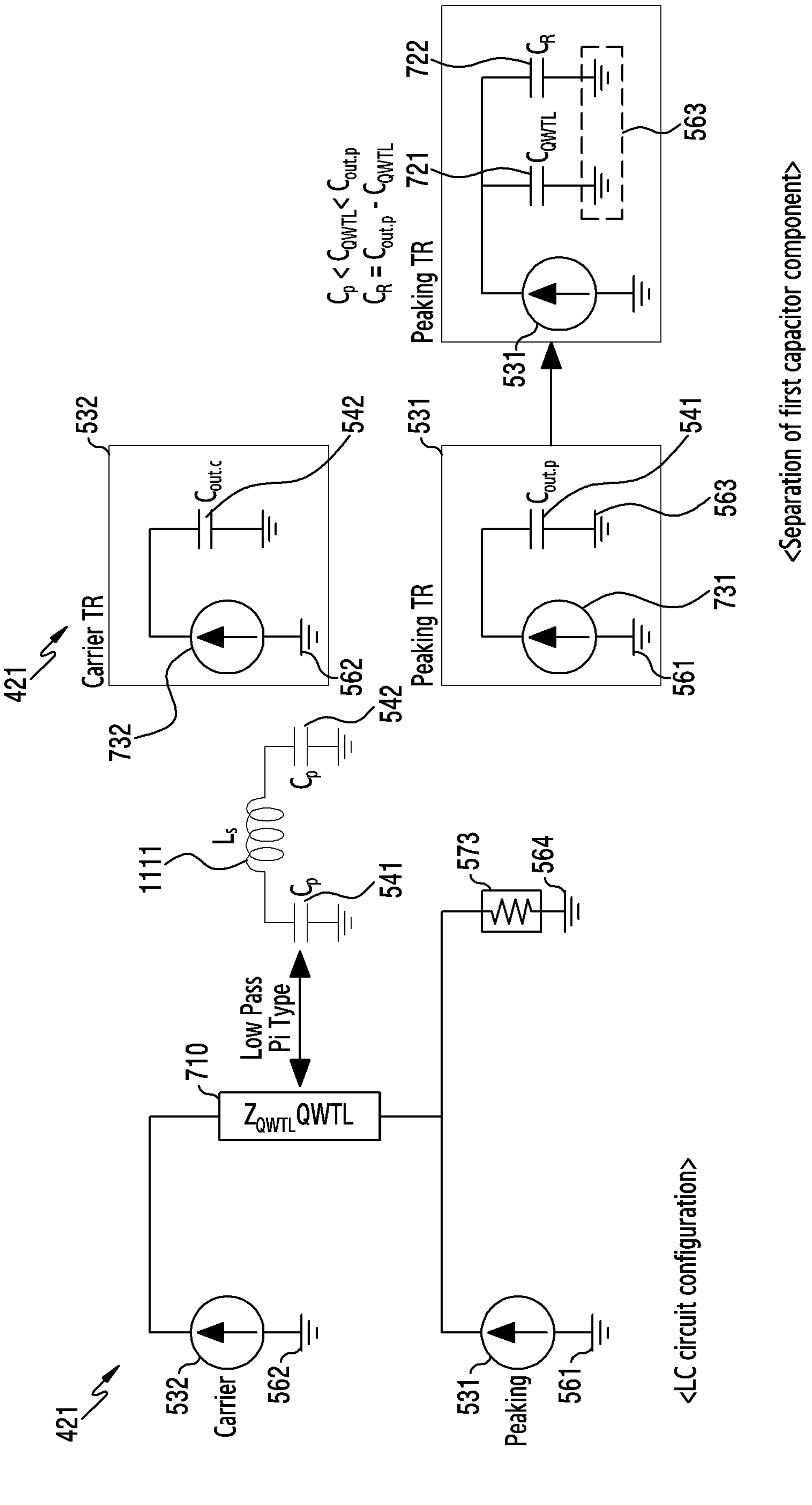
421
Carrier
532
562
Peaking
531
561
Z<sub>QWTL</sub> QWTL
710
Low Pass
Pi Type
573
564
<LC circuit configuration>
1111
$L_s$
$C_p$
541
542
732
Carrier TR
$C_{out.c}$
Peaking TR
$C_{out.p}$
563
731
$C_p < C_{QWTL} < C_{out.p}$
$C_R = C_{out.p} - C_{QWTL}$
721
722
$C_{QWTL}$
$C_R$
<Separation of first capacitor component>

FIG.11

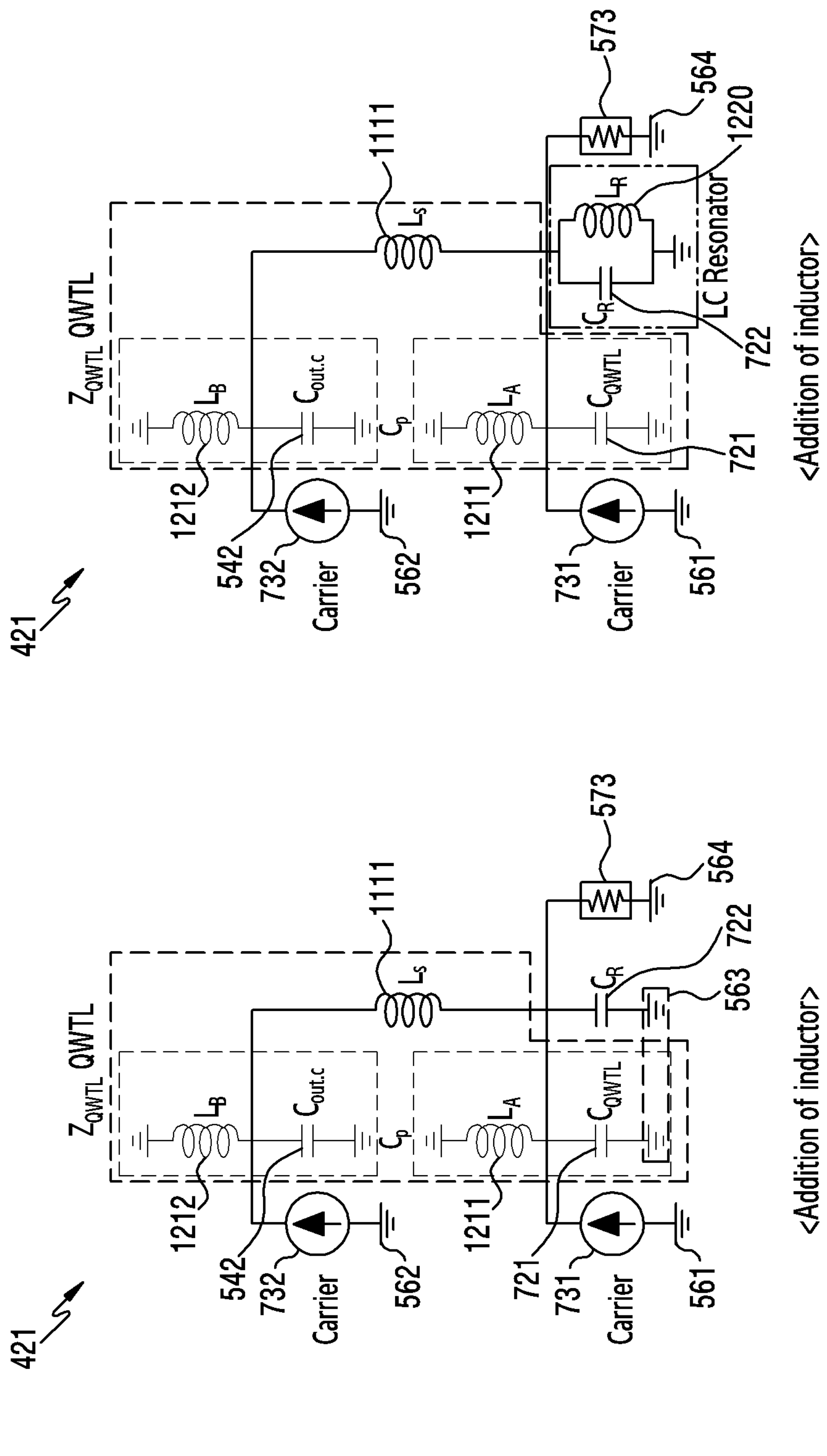

421
$Z_{QWTL}$ QWTL
1212
$L_B$
542
732
Carrier
562
$C_{out.c}$
$C_p$
1211
$L_A$
731
Carrier
561
$C_{QWTL}$
721
1111
$L_s$
$C_R$
722
1220
$L_R$
LC Resonator
573
564
<Addition of inductor>
421
$Z_{QWTL}$ QWTL
1212
$L_B$
542
732
Carrier
562
$C_{out.c}$
$C_p$
1211
$L_A$
721
731
Carrier
561
$C_{QWTL}$
1111
$L_s$
$C_R$
722
563
573
564
<Addition of inductor>


FIG.12

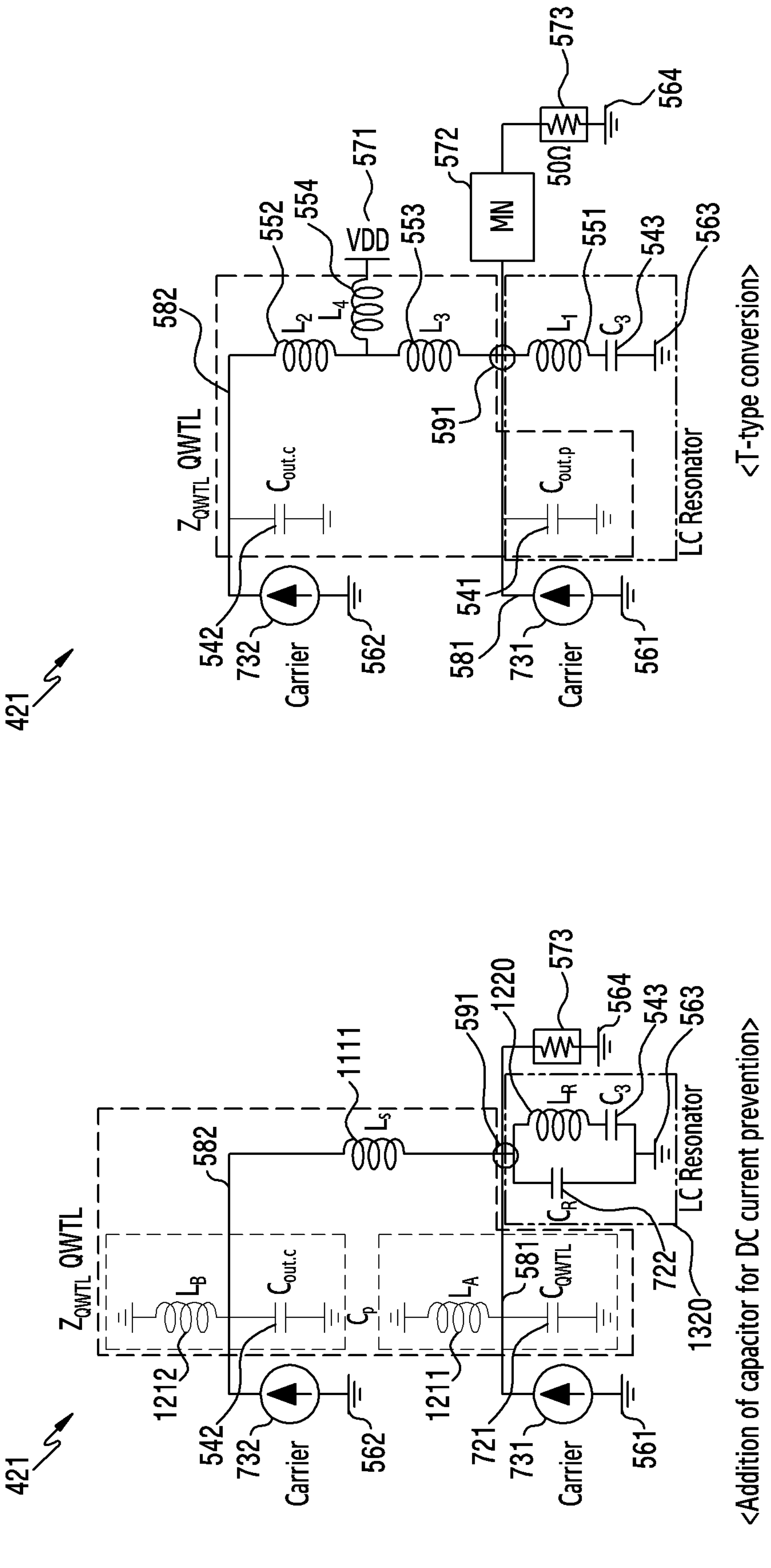
421
Carrier
Carrier
542
732
562
581
731
561
541
582
$Z_{QWTL}$ QWTL
$C_{out.c}$
$C_{out.p}$
LC Resonator
591
$L_2$
$L_4$
$L_3$
$L_1$
$C_3$
552
554
553
551
543
563
VDD
571
MN
572
50Ω
573
564
<T-type conversion>
421
1212
542
732
562
1211
721
731
561
$L_B$
$C_{out.c}$
$C_p$
$L_A$
$C_{QWTL}$
581
582
$L_S$
1111
591
1220
$L_R$
$C_3$
$C_R$
573
564
543
563
722
1320
<Addition of capacitor for DC current prevention>

FIG.13

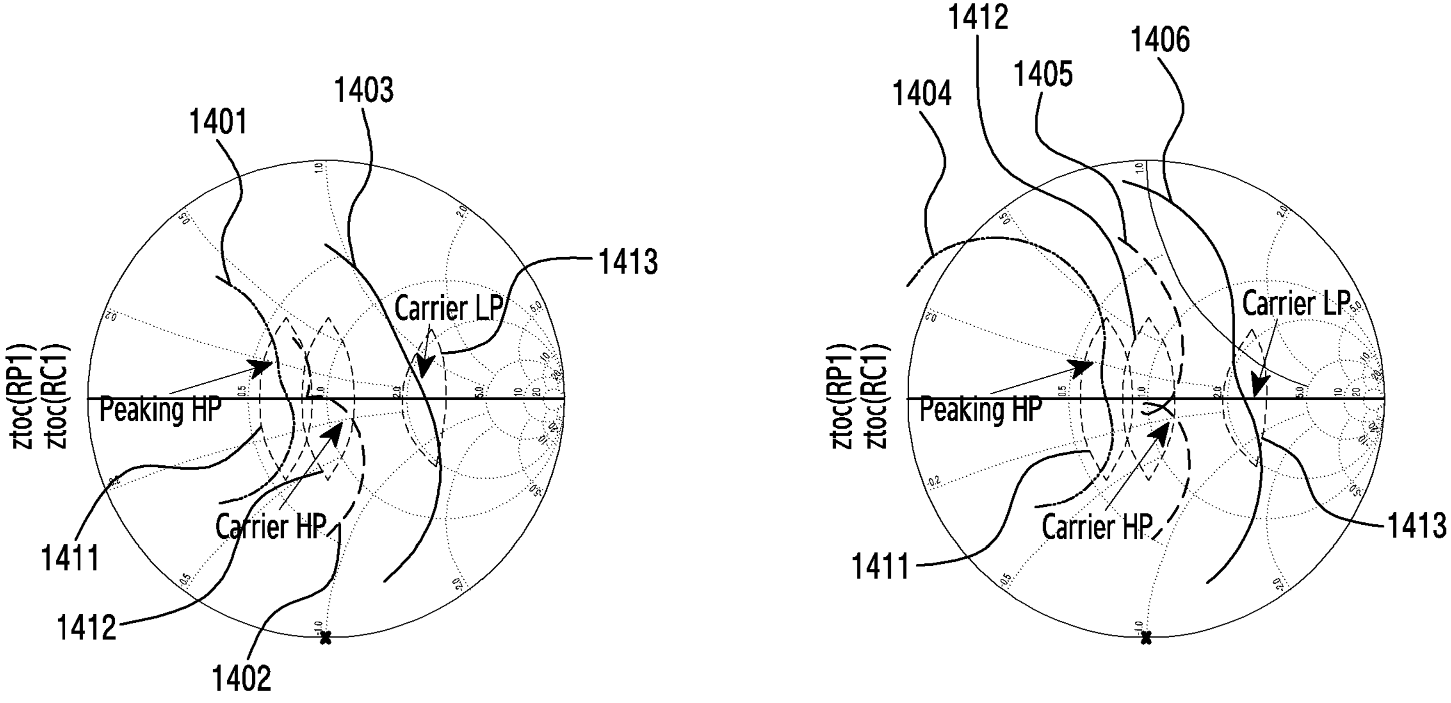


freq (2.400 GHz to 4.800 GHz)

<When there is no first inductor and third capacitor>

freq (2.400 GHz to 4.800 GHz)

<When there are first inductor and third capacitor>

FIG.14